(19) **Europäisches Patentamt**
**European Patent Office**
**Office européen des brevets**

(11) **EP 2 999 311 A1**

(12) **EUROPEAN PATENT APPLICATION**
published in accordance with Art. 153(4) EPC

(43) Date of publication:
**23.03.2016 Bulletin 2016/12**

(21) Application number: **14797010.7**

(22) Date of filing: **21.04.2014**

(51) Int Cl.:
**H05B 33/10** (2006.01)     **H01L 51/50** (2006.01)
**H05B 33/02** (2006.01)     **H05B 33/26** (2006.01)

(86) International application number:
**PCT/JP2014/061162**

(87) International publication number:
**WO 2014/185224 (20.11.2014 Gazette 2014/47)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **17.05.2013 JP 2013105474**
**31.01.2014 JP 2014016984**

(71) Applicant: **Asahi Glass Company, Limited**
**Tokyo 100-8405 (JP)**

(72) Inventors:
• **NAKAMURA, Nobuhiro**
**Tokyo 100-8405 (JP)**
• **TACHIBANA, Yuko**
**Tokyo 100-8405 (JP)**
• **ISHIBASHI, Nao**
**Tokyo 100-8405 (JP)**

(74) Representative: **Müller-Boré & Partner**
**Patentanwälte PartG mbB**
**Friedenheimer Brücke 21**
**80639 München (DE)**

(54) **ORGANIC LED ELEMENT AND METHOD FOR PRODUCING ORGANIC LED ELEMENT**

(57)     [Means of Solution]
An organic LED element having a plurality of light emitting regions that are connected in series is provided, wherein
the light emitting regions include a first electrode and a second electrode, between two adjacent light emitting regions,
the first electrode of one light emitting region and the second electrode of another light emitting region are connected via a barrier layer, and
a C concentration in an interface region between the first electrode and the barrier layer, or an interface region between the second electrode and the barrier layer, is 10 atomic % or lower.

FIG.1

**Description**

TECHNICAL FIELD

The present invention relates to an organic LED element and a method of manufacturing the organic LED element.

BACKGROUND ART

Recently, there is active research and development of new optical devices such as a Plasma Display Panel (PDP), a Field Emission Display (FED), an organic LED (Light Emitting Diode), an organic EL element, or the like. Much attention is drawn to the organic LED element as one of the next-generation light emitting elements. The organic LED element has a structure in which an organic layer is sandwiched between electrodes, and a light emitting mechanism injects holes and electrons from the respective electrodes by applying a voltage across the electrodes, and causes the holes and electrons to couple within the organic layer to excite a light emitting material within the organic layer. Thereafter, light, that is generated as the light emitting material in the excited state reaches the ground state, is extracted. Particular examples of the usage of the organic LED element include use in display, backlight, lighting, or the like.
For example, Patent Document 1 describes a structure of the organic LED element including main parts 2a of a first electrode line forming pixels that are formed as a plurality of isolated patterns on a substrate, an insulating layer having openings at isolated pattern group parts of the first electrode, a light emitting medium 4 formed at a predetermined part including a light emitting part of each isolated pattern, and second electrode main parts 5a formed so as to connect to an adjacent isolated pattern on the light emitting medium. The described organic electroluminescence element has a pixel part formed by a plurality of single organic electroluminescence elements, and the plurality of single organic electroluminescence elements are connected in series.

PRIOR ART DOCUMENTS

PATENT DOCUMENTS

Patent Document 1: Japanese Laid-Open Patent Publication No. 2000-029404

DISCLOSURE OF THE INVENTION

PROBLEM TO BE SOLVED BY THE INVENTION

However, in the organic LED element having the series-connected structure described above, a composite oxide forming the first electrode that is a transparent electrode, and the second electrode that is a metal electrode, are in direct contact within the structure. For this reason, when a current is applied across the two electrodes, oxygen within the composite oxide forming the transparent electrode diffuses to the side of the metal electrode, and there is a problem in that a resistance value of the metal electrode rises. In addition, when impurities such as carbon or the like mix into an interface part between the transparent electrode and the metal electrode, the impurities or the like also cause the resistance value between the electrodes.
When the current flows in a state in which the resistance value rises at the interface part between the transparent electrode and the metal electrode, oxidization of the metal electrode further progresses because the interface part generates heat, and the element may break down in a case in which the interface part burns out due to the generated heat. For example, in usages such as for use in lighting where a large current is continuously applied, there is a problem in that the diffusion of oxygen and the increase of an amount of generated heat progress more easily.
The present invention is conceived in view of the problems of the above conventional technique, and one object is to provide an organic LED element that suppresses the increase of the resistance in a vicinity of the interface between 2 electrodes forming the organic LED element.

MEANS OF SOLVING THE PROBLEM

The present invention provides an organic LED element comprising a plurality of light emitting regions that are coupled in series, wherein
the light emitting regions include a first electrode and a second electrode,
between two adjacent light emitting regions, the first electrode of one light emitting region and the second electrode of another light emitting region are connected via a barrier layer, and

a C concentration in an interface region between the first electrode and the barrier layer, or an interface region between the second electrode and the barrier layer, is 10 atomic % or lower.

In addition, the present invention provide an organic LED element comprising a plurality of light emitting regions that are coupled in series, wherein

the light emitting regions include a first electrode and a second electrode,

between two adjacent light emitting regions, the first electrode of one light emitting region and the second electrode of another light emitting region are connected via a barrier layer, and

an O concentration in an interface region between the second electrode and the barrier layer is 20 atomic % or lower.

Further, the present invention provides an organic LED element comprising a plurality of light emitting regions that are coupled in series, wherein

the light emitting regions include a first electrode and a second electrode,

between two adjacent light emitting regions, the first electrode of one light emitting region and the second electrode of another light emitting region are connected via a barrier layer, and

an H concentration in an interface region between the first electrode and the barrier layer, or an interface region between the second electrode and the barrier layer, is 5 atomic % or lower.

In the organic LED element of the present invention, the interface region between the first electrode and the barrier layer may include a compatible layer.

In the organic LED element of the present invention, the interface region between the second electrode and the barrier layer may include a compatible layer.

In the organic LED element of the present invention, the barrier layer may be formed by a metal or an alloy of the metal including one or more elements selected from Cr, Mo, Ti, Ta, Pd, and Pt.

In the organic LED element of the present invention, the organic LED element may be formed on a substrate, and the substrate may include a light extracting layer.

In addition, the present invention provides a method of manufacturing an organic LED element having a plurality of light emitting regions that are coupled in series, comprising:

a first electrode forming step to form a first electrode;
a barrier forming step to form a barrier layer; and
a second electrode forming step to form a second electrode,

wherein each of the steps is carried out under an atmosphere in which a C concentration is $5.0 \times 10^{21}$ atoms/m$^3$ or lower, at least during a time from a start of the first electrode forming step to an end of the barrier layer forming step, or during a time from a start of the barrier layer forming step to an end of the second electrode forming step.

Moreover, the present invention provides a method of manufacturing an organic LED element having a plurality of light emitting regions that are coupled in series, comprising:

a first electrode forming step to form a first electrode;
a barrier forming step to form a barrier layer; and
a second electrode forming step to form a second electrode,

wherein each of the steps is carried out under an atmosphere in which an O concentration is $5.0 \times 10^{24}$ atoms/m$^3$ or lower, at least during a time from a start of the first electrode forming step to an end of the barrier layer forming step, or during a time from a start of the barrier layer forming step to an end of the second electrode forming step.

Further, the present invention provides a method of manufacturing an organic LED element having a plurality of light emitting regions that are coupled in series, comprising:

a first electrode forming step to form a first electrode;
a barrier forming step to form a barrier layer; and
a second electrode forming step to form a second electrode,

wherein each of the steps is carried out under an atmosphere in which an H concentration is $5.0 \times 10^{22}$ atoms/m$^3$ or lower, at least during a time from a start of the first electrode forming step to an end of the barrier layer forming step, or during a time from a start of the barrier layer forming step to an end of the second electrode forming step.

In the method of manufacturing the organic LED element of the present invention, the barrier layer may be formed by a metal or an alloy of the metal including one or more elements selected from Cr, Mo, Ti, Ta, Pd, and Pt.

In the method of manufacturing the organic LED element of the present invention, the organic LED element may be formed on a substrate, and the substrate may include a light extracting layer.

EFFECTS OF THE INVENTION

The present invention can provide an organic LED element that suppresses the increase of the resistance in a vicinity of the interface between 2 electrodes forming the organic LED element.

BRIEF DESCRIPTION OF THE DRAWING

FIG. 1 is a top view of an organic LED element in a first embodiment of the present invention.
FIG. 2 is a cross sectional view along a line A-A' in FIG. 1.
FIG. 3 is a diagram for explaining a structure of an apparatus for measuring a change in a contact resistance with lapse of time between a transparent electrode and a metal electrode.
FIG. 4 illustrates measured results of the change in the contact resistance with lapse of time between the transparent electrode and the metal electrode.
FIG. 5 is a diagram for explaining an interface region.
FIG. 6 is a diagram for explaining a structure of a sample for measuring the contact resistance in a reference example 1.
FIG. 7 illustrates measured results of the contact resistance for a sample No. 1-3-1 and a sample No. 1-3-2 of the reference example 1.
FIG. 8 is a diagram for explaining a relationship between a power consumption increase rate and an interface O concentration of the reference example 1.
FIG. 9 is a diagram for explaining a pattern of each layer forming the organic LED element made in an exemplary implementation 1.
FIG. 10 is a diagram for explaining a light emitting region and a stacked structure of the organic LED element made in the exemplary implementation 1.
FIG. 11 is a photograph of a state at a time of light emission of the organic LED element made in the exemplary implementation 1.
FIG. 12 is a photograph of a state at the time of the light emission of the organic LED element made in an exemplary implementation 2.

MODE OF CARRYING OUT THE INVENTION

[First Embodiment]

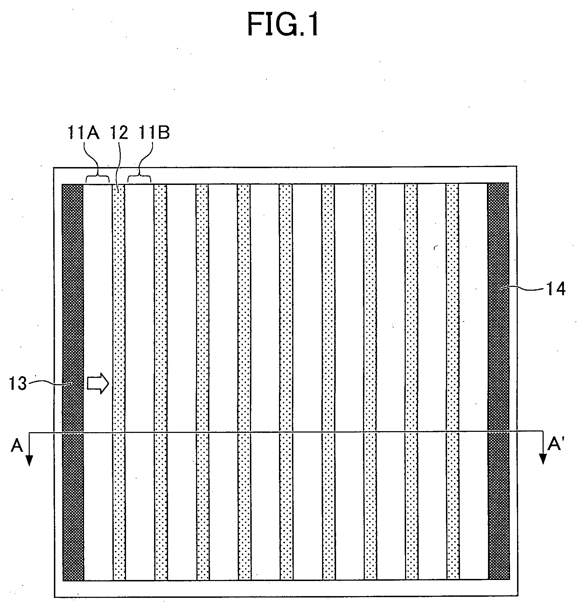

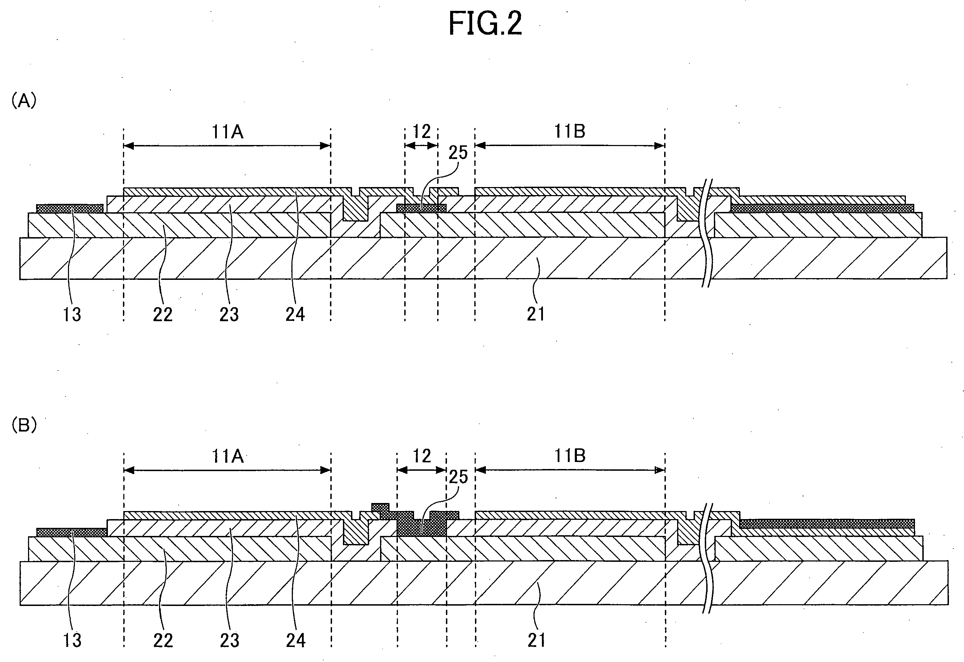

A description will be given of an example of a structure of an organic LED element in this embodiment.
The organic LED element in this embodiment is an organic LED element in which a plurality of light emitting regions are connected in series. The light emitting region includes a first electrode and a second electrode, and the first electrode of one of adjacent light emitting regions is connected to the second electrode of the other of the adjacent light emitting regions via a barrier layer. A C (carbon) concentration in an interface region between the first electrode and the barrier layer, or in an interface region between the second electrode and the barrier layer, is 10 atomic % or lower.
A description will be given of the structure of the organic LED element in this embodiment, by referring to FIGs. 1 and 2. FIG. 1 is a top view of the organic LED element, and FIG. 2 is a cross sectional view along a line A-A' in FIG. 1, and both views are schematic views. FIG. 2 illustrates, on an enlarged scale, the light emitting regions amounting to 2 stages amongst the light emitting regions that are connected in series in 10 stages in FIG. 1.
As illustrated in FIG. 1, the organic LED element in this embodiment includes a plurality of light emitting regions 11 (11A, 11B, etc.), and these light emitting regions 11 are connected in series via contact regions 12. For this reason, by supplying a current from a part of a leader line 13, the current successively flows through each of the light emitting regions 11 towards another leader line 14, and it is possible to cause each light emitting region 11 to emit light.
A description will be given of a particular example of the structure of the organic LED element in this embodiment, by referring to FIG. 2. As illustrated in FIG. 2, the organic LED element in this embodiment may be formed on a substrate 21, for example. In addition, the light emitting regions 11A and 11B have a structure in which a first electrode 22, a light emitting part 23, and a second electrode 24 are stacked. In a contact region 12, the second electrode 24 of the light emitting region 11A and the first electrode 22 of the adjacent light emitting region 11B are connected via a barrier layer 25. For this reason, the current supplied from the leader wire 13 first flows in the order of the first electrode 22 of the light emitting region 11A adjacent to a region in which the leader wire 13 is provided, the light emitting part 23, and the second electrode 24. Then, the current flows through the barrier layer 25 in the contact region 12, to the first electrode 22 of the adjacent light emitting region 11B, and the current is successively supplied to the adjacent light emitting regions.

In FIG. 1 illustrates an example in which the light emitting regions 11 are provided in 10 stages, however, the number of stages of light emitting regions is not limited to 10 stages, and may be selected arbitrarily according to an area of the organic LED element, an amount of current to be supplied, or the like. In addition, although the areas of the light emitting regions does not need to be constant within the organic LED element, it is preferable that the light emitting areas are uniform so that each of the light emitting regions have a uniform brightness.

By segmenting the light emitting part of the organic LED element into the plurality of light emitting regions 11 and connecting the plurality of light emitting regions 11 in series, it is possible to cause all of the light emitting regions to emit light by simply supplying the current required to cause one light emitting region 11 to emit light, and the required amount of current can be reduced. For this reason, the organic LED element in this embodiment is preferably applicable for use in lighting that requires a large current, for example. This embodiment is preferably applicable particularly to an organic LED element having a luminance of 2000 cd/m$^2$ or higher. In addition, because the large current is also required in the case of an organic LED element having the light emitting region with a large area, this embodiment is preferably applicable to an organic LED element having the light emitting region with an area of 50 cm$^2$ or greater, and more preferably applicable to an organic LED element having the light emitting region with an area of 100 cm$^2$ or greater.

As described above, in the organic LED element in this embodiment, the first electrode 22 and the second electrode 24 of the adjacent light emitting regions 11 are connected via the barrier layer 25.

The barrier layer 25 and a structure in a vicinity thereof are not limited to a particular structure, as long as the first electrode 22 of one light emitting region and the second electrode 24 of the other light emitting region are connected via the barrier layer 25. For example, as illustrated in FIG. 2 (A), in the contact region 12, the barrier layer 25 and the second electrode 24 of the light emitting region 11A may be stacked on the first electrode 22 of the light emitting region 11B. In addition, as illustrated in FIG. 2 (B), it is possible not to arrange the barrier layer 25 on the second electrode 24 of the light emitting region 11A in the contact region 12, arrange the barrier layer 25 on the first electrode 22 of the light emitting region 11B, and extend the barrier layer 25 to the light emitting region 11A and connect the barrier layer 25 to the second electrode 24 of the light emitting region 11A.

In the contact region of the organic LED element in this embodiment, the current flows within the barrier layer in a direction along a thickness of the glass substrate, and for this reason, a resistance of the barrier layer is not limited to a particular resistance. For example, a sheet resistance of the barrier layer is preferably 1 Ω/□ or lower, more preferably 0.5 Ω/□ or lower, and particularly more preferably 0.3 Ω/□ or lower.

The structure of the barrier layer is also not limited to a particular structure, and the barrier layer may be formed by a single metal layer, for example.

As described above, in the invention described in Patent Document 1, the composite oxide forming the first electrode that is the transparent electrode, and the second electrode that is the metal electrode, are in direct contact within the structure. For this reason, when the current is applied across the two electrodes, oxygen within the composite oxide forming the transparent electrode diffuses to the side of the metal electrode. A description will be given on this point.

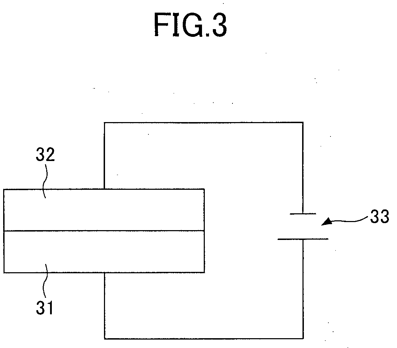

As illustrated in FIG. 3, a layer made of Al is formed as a metal electrode 32 on a layer made of ITO that becomes a transparent electrode 31, and a change with lapse of time was observed by connecting a power supply 33 to the transparent electrode 31 and the metal electrode 32.

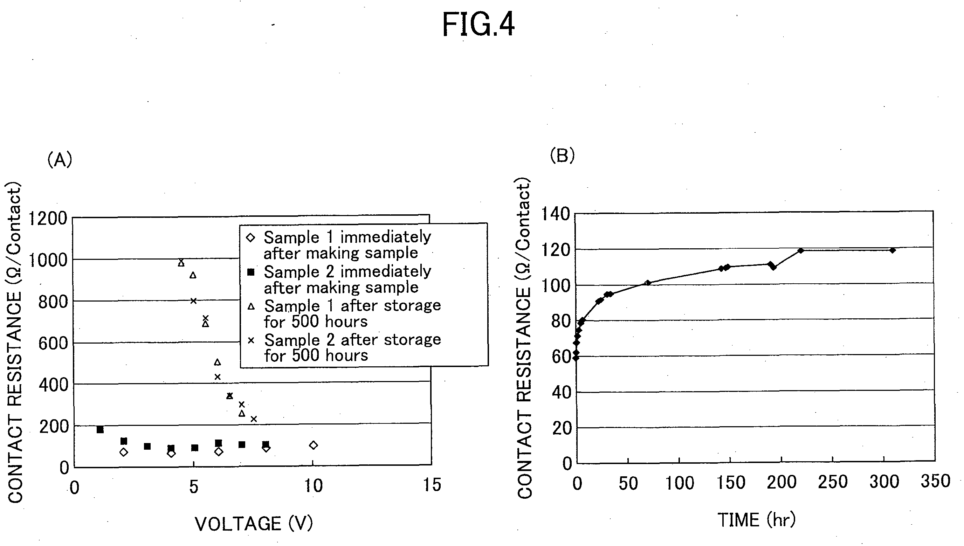

As illustrated in FIG. 4 (A), changes in the resistance with respect to the applied voltage (hereinafter also referred to as "contact resistance") immediately after manufacturing samples illustrated in FIG. 3 were measured. A contact area between the ITO and the metal electrode was 200 μm□ (or 40000 μm$^2$). It may be seen that samples 1 and 2 immediately after manufacturing the samples in FIG. 4 (A) both show a low contact resistance. However, when the changes in the resistance with respect to the applied voltage were measured in a similar manner after storing the samples for 500 hours in an atmospheric environment heated to a temperature of 105°C, it may be confirmed that the samples 1 and 2 after the storage for 500 hours in FIG. 4 (A) both show a rise in the contact resistance.

In addition, when the current of 300 mA was continuously supplied to the sample immediately after manufacturing the sample in the atmospheric environment at room temperature, it was confirmed that the contact resistance gradually rises as illustrated in FIG. 4 (B).

According to the above experiments, it was confirmed that, in a case in which the organic LED element has the conventional structure in which the transparent electrode and the metal electrode are in direct contact, the contact resistance rises with the lapse of time. It may be regarded that this rise is caused by the oxygen within the transparent electrode diffusing to the side of the metal electrode, to thereby increase the resistance of the metal electrode in a vicinity of the interface between the two electrodes.

On the other hand, in the organic LED element in this embodiment, the barrier layer 25 is provided between the first electrode 22 of one light emitting region and the second electrode 24 of the other light emitting region. For this reason, even in a case in which one of the first electrode 22 of one light emitting region and the second electrode 24 of the other light emitting region is used as the transparent electrode and the other of these first and second electrodes 22 and 24 is used as the metal electrode, it is possible to suppress the oxygen from diffusing to the side of the metal electrode, and thus, it is possible to suppress the resistance value from rising in the vicinity of the interface of the two electrodes.

In addition, even in the case in which the barrier layer 25 is provided between the first electrode 22 of one light emitting region and the second electrode 24 of the other light emitting region, the contact resistance may become high due to the effects of the impurities, if the impurity concentration is high in an interface region between the first electrode 22 of one light emitting region and the barrier layer 25, or in an interface region between the second electrode 24 of the other light emitting region and the barrier layer 25. An example of the impurities includes carbon. When the contact resistance becomes high, heat is generated at the interface region between the barrier layer 25 and the first electrode 22 or the second electrode 24, and the interface part between the barrier layer 25 and the first electrode 22 of one light emitting region or the second electrode 24 of the other light emitting region may break down depending on the amount of generated heat.

Hence, in the organic LED element in this embodiment, a C (carbon) concentration in the interface region between the barrier layer 25 and the first electrode 22 of one light emitting region, or in the interface region between the barrier layer 25 and the second electrode 24 of the other light emitting region, is preferably 10 atomic % or lower. By setting the C concentration in the interface region between the barrier layer 25 and the first electrode 22 or the second electrode 24 in the above range, it is possible to suppress a rise in the contact resistance between the barrier layer 25 and the first electrode 22 or the second electrode 24, to thereby suppress the breakdown of the organic LED element. Particularly, the C (carbon) concentration in the interface region between the barrier layer 25 and the first electrode 22 of one light emitting region, and the C concentration in the interface region between the barrier layer 25 and the second electrode 24 of the other light emitting region are preferably set in the above range. In this case, it is possible to more positively suppress the rise in the contact resistance in the interface regions, and suppress the breakdown of the organic LED element.

The C concentration in the interface region between the barrier layer 25 and the first electrode 22 of one light emitting region, or the C concentration in the interface region between the barrier layer 25 and the second electrode 24 of the other light emitting region, is more preferably 5 atomic % or lower. The C concentration in the interface region between the barrier layer 25 and the first electrode 22 of one light emitting region, and the C concentration in the interface region between the barrier layer 25 and the second electrode 24 of the other light emitting region, are particularly more preferably 5 atomic % or lower.

Next, a description will be given of the interface region. A description will be given of the interface region between the second electrode 24 and the barrier layer 25, as an example.

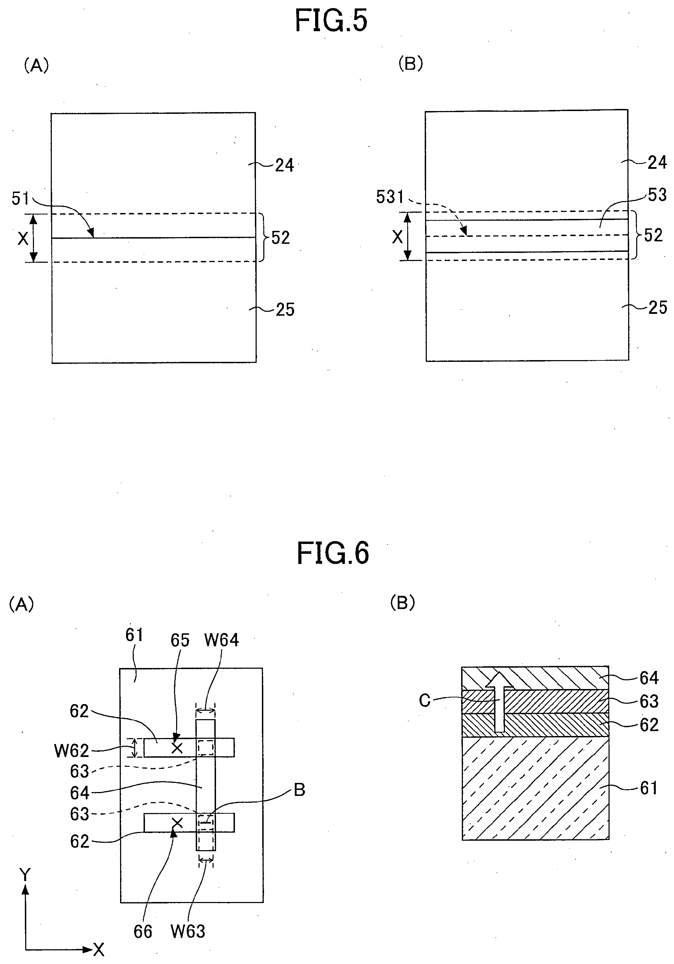

As illustrated in FIG. 5 (A), in a case in which an interface 51 between the second electrode 24 and the barrier layer 25 can be identified by TEM or the like, for example, the interface 51 is regarded as the interface between the second electrode 24 and the barrier layer 25. A range having a width of 10 nm with reference to the interface 51 as its center, that is, a range indicated by an arrow X in FIG. 5 (A), is regarded as an interface region 52.

In addition, as illustrated in FIG. 5 (B), in a state in which constituent elements of the second electrode 24 and the barrier layer 25 coexist in a periphery of the interface between these 2 layers, that is, in a case in which a compatible layer 53 is formed but an interface thereof is unclear, a center part 531 of the compatible layer 53 (when viewed in a layer-stacking direction of the second electrode 24 and the barrier layer 25) is regarded as the interface between the second electrode 24 and the barrier layer 25. A range having a width of 10 nm with reference to the interface (center part 531) as its center, that is, a range indicated by an arrow X in FIG. 5 (B), is regarded as the interface region 52.

The interface region between the second electrode 24 and the barrier layer 25 is described above as an example of the interface region. However, the interface region between the first electrode 22 and the barrier layer 25 can be prescribed in a similar manner. The interface region between the first electrode 22 and the barrier layer 25 may also have a structure including the compatible layer.

A method of measuring the C concentration of the interface region 52 is not limited to a particular method, and an arbitrary method may be used for the measurement. For example, the measurement may be performed using a TEM (Transmission Electron Microscope), an XPS (X-ray Photo-electron Spectroscopy), an RBS (Rutherford Back-scattering Spectroscopy), an ERDA (Elastic Recoil Detection Analysis), or the like.

In a case in which the spectroscopy or analysis other than the TEM is used, it is possible to make an observation in advance using the TEM, and prescribe the position of the interface 51.

In addition, the positions of the first electrode or the second electrode and the barrier layer, and in some cases the compatible layer, may be determined from distributions of elements forming the first electrode or the second electrode and elements included in the barrier layer, for example. For this reason, even in the case in which the spectroscopy or analysis other than the TEM is used, it is possible specify the interface and the interface region from the distributions of these elements, without having to specify the position of the interface 51 in advance using the TEM.

As described above, in this embodiment, a case in which the interface that is a boundary of 2 layers clearly appears between the first electrode or the second electrode and the barrier layer, and a case in which the compatible layer is formed in the periphery of the interface of the 2 layers and the boundary does not clearly appear, are assumed.

In the case in which the boundary of the 2 layers clearly appears, the C concentration or the like is detected in the interface region in addition to the constituent elements of each of the layers. Even in the case in which the boundary of the 2 layers clearly appears, the interface may be determined in a manner similar to the case in which the compatible layer appears when the boundary is detected as a broad interface. More particularly, the center part of the broad interface in the direction in which the layers are stacked may be regarded as the interface that is used when prescribing the interface region. In addition, in the case in which the boundary of the 2 layers becomes the compatible layer, the C concentration or the like is detected in addition to the constituent elements of both the layers.

A description will be given of each member of the organic LED element in this embodiment.

<First Electrode>

The first electrode 22 is preferably formed by a transparent electrode (or translucent electrode). In this case, in order to extract the light generated at the light emitting part 23 to the outside, the transparent electrode has a translucency of 80% or higher. In addition, in order to inject a large amount of holes, a work function of the transparent electrode is preferably high. In a case in which the series connection is used, the amount of current that is required may be smaller compared to a case in which the series connection is not used with respect to the same light emitting area, and the resistance of the transparent electrode may be high. More particularly, the resistance of the transparent electrode may be 100 $\Omega/\square$ or lower, desirably 50 $\Omega/\square$ or lower, and more desirably 30 $\Omega/\square$ or lower.

More particularly, a composite oxide material such as ITO (Indium Tin Oxide), $SnO_2$, ZnO, IZO (Indium Zinc Oxide), AZO (ZnO-$Al_2O_3$: zinc oxide doped with aluminum), GZO (ZnO-$Ga_2O$: zinc oxide doped with gallium), Nb-doped $TiO_2$, Ta-doped $TiO_2$, or the like may be preferably used for the transparent electrode, for example. Even in a case in which ITO is used for the transparent electrode, the resistance may be high compared to that of the conventional transparent electrode, and thus, it is possible to reduce the layer thickness and improve the transmittance. More particularly, the layer thickness of ITO may be 10 nm or greater and 150 nm or less, desirably 30 nm or greater and 120 nm or less, and more desirably 50 nm or greater and 100 nm or less, for example.

The thickness of the first electrode 22 is not limited to a particular thickness, but is preferably 100 nm or greater. A refractive index of the first electrode 22 is preferably 1.9 to 2.2. In the case of ITO, the refractive index of the ITO can be reduced when a carrier concentration thereof is increased. Generally, the ITO on the market typically includes 10 wt% of $SnO_2$, but the refractive index of the ITO can be reduced by increasing the Sn concentration. The carrier concentration increases by increasing the Sn concentration, however, the mobility and transmittance decrease, and thus, the amount of Sn is preferably determined by balancing the refractive index, mobility, and transmittance.

<Second Electrode>

The second electrode 24 is preferably formed by a metal having a small work function or an alloy thereof. Examples of the material that may be used for the second electrode 24 includes alkali metals, alkali earth metals, and metals in group 13 of the periodic table, or the like. Aluminum (Al), magnesium (Mg), alloys these metals, or the like may preferably be used for the second electrode, because such materials are inexpensive and chemically stable. In addition, co-deposited layers of Al and MgAg, a stacked electrode having Al deposited on deposited layer of LiF or $Li_2O$, or the like in particular may be preferably used for the second electrode. Further, in a case in which a high-molecular material is used for a light emitting material that will be described later, a stacked layer of calcium (Ca) or barium (Ba) and aluminum (Al), or the like may be used for the second electrode.

Either one of the first electrode and the second electrode may be an anode or cathode. For example, the first electrode may be the anode, and the second electrode may be the cathode.

<Barrier Layer>

As described above, because the barrier layer 25 is a member that electrically connects the first electrode 22 and the second electrode 24, the barrier layer 25 is not limited to a particular material as long as the material is conductive. The conductive material is preferably a made of a material that can suppress the diffusion between the two electrodes, that is, the diffusion of oxygen, for example. Preferable examples of such a conductive material of the barrier layer 25 include metals including one or more elements selected from Cr, Mo, Ti, Ta, Pd, and Pt, and alloys of such elements. From a viewpoint of cost or the like, the conductive material is a metal selected from Cr and Mo, or an alloy of the metal selected from Cr and Mo. Examples of the alloy of the metal selected from Cr and Mo include NiMo, MoNb, or the like.

As described above, the barrier layer 25 simply needs to electrically connect the first electrode 22 and the second electrode 24 in the contact region 12. The size of the barrier layer 25 is not limited to a particular size, and may be formed to a size tolerated within the organic LED element. However, the barrier layer 25 is preferably formed to secure a distance between the two electrodes, so that the diffusion of material between the first electrode 22 and the second electrode 24 can be suppressed sufficiently. For example, in the case of the structure in which the barrier layer 25 and the second electrode 24 are stacked on the first electrode 22 as illustrated in FIG. 2 (A), the layer thickness of the barrier layer 25 is preferably 10 nm or greater. In this case, an upper limit of the barrier layer thickness is not limited to a particular value, and may be selected according to the thickness of the light emitting part 23 or the like.

In addition, in the organic LED element in this embodiment, a width of the contact region 12 is not limited to a particular width, and may be selected according to the supplied current value or the like. However, because the contact region 12 electrically connects the first electrode 22 of one light emitting region and the barrier layer 25, the width of the contact region 12 is preferably 50 $\mu$m or greater, and more preferably 200 $\mu$m or greater, so that a sufficiently large current flows. Further, in the case in which the first electrode 22 of one light emitting region is the transparent electrode and the second electrode 24 of the other light emitting region is the metal electrode as described above, the resistance value of the first electrode 22 of one light emitting region in general becomes higher than that of the second electrode 24 of the other light emitting region. For this reason, even when the width of the contact region 12 is set wide, a region in which the current actually flows corresponds only to a part of the contact region. Moreover, because the light emitting part 23 is not provided in the contact region 12, a region between the light emitting regions becomes visible when the contact region is set wide, which is not preferable from a viewpoint of external appearance. Hence, the width of the contact region 12 is preferably 500 $\mu$m or less, and more preferably 300 $\mu$m or less.

The width of the contact regions 12 does not need to be constant within the organic LED element, and the width may be selected for each contact region 12. However, the width of the contact regions 12 is preferably constant within the organic LED element, in order to make the luminance of each of the light emitting regions 11 constant within the organic LED element. In addition, in a case in which the width of the contact region 12 is set wide, a scattering layer which will be described later is preferably provided between the first electrode and the substrate to scatter light from the light emitting regions, so that the contact region 12 does not become conspicuous, that is, the region between the light emitting regions 11 does not become wide and visible.

The organic LED element in this embodiment may include each of the following members in addition to the members described above.

<Substrate>

As illustrated in FIG. 2 (A) and (B), the organic LED element in this embodiment can be formed on the translucent substrate 21. The material used for the translucent substrate 21 is not limited to a particular material, however, the material used preferably has a high transmittance with respect to visible light. Preferable examples of the substrate material having the high transmittance with respect to the visible light includes glass substrate and plastic substrate materials.

The glass substrate material may preferably utilize inorganic glass such as alkali glass, alkalifree glass, quartz glass, or the like. In addition, the plastic substrate material may preferably utilize polyester, polycarbonate, polyether, polysulfone, polyvinyl alcohol, and fluorine-containing polymers such as polyvinylidene fluoride and polyvinyl fluoride, or the like. In order to prevent moisture from permeating through the substrate, the plastic substrate may be configured to possess barrier properties. The thickness of the translucent substrate 21 is preferably 0.1 mm to 2.0 mm in the case of glass. However, because the strength deteriorates if the substrate is too thin, the substrate thickness of 0.5 mm to 1.0 mm is particularly preferable.

<Leader Line>

In the organic LED element in this embodiment, it is possible to arrange the leader lines 13 and 14 for supplying the current with respect to the organic LED element. The material used for the leader lines is not limited to a particular material, and the material used may be the same as that of the barrier layer 25, for example. In this case, it is preferable in that the leader lines can be formed when forming the barrier layer 25.

<Light Emitting Part>

The light emitting part 23 has a light emitting function, and may be formed by a hole injecting layer, a hole transport layer, an emissive layer, an electron transport layer, and an electron injecting layer. The refractive index of the light emitting part 23 is preferably 1.7 to 1.8. A description will hereunder be given of each of the layers of the light emitting part.

<Hole Injection Layer>

The material used for the hole injecting layer preferably has a small ionization potential difference, in order to lower a hole injecting barrier from the anode. An improvement in an injection efficiency of charge from an electrode interface at the hole injecting layer reduces a driving voltage of the element and also increases the injection efficiency of the charge. A high-molecular material such as polyethylenedioxythiophene (PEDOT: PSS) doped with polystyrene sulfonic acid PSS), and a low-molecular material such as phthalocyanines including copper phthalocyanine (CuPc), may preferably be used for the hole injecting layer.

<Hole Transport Layer>

The hole transport layer as a function to transport holes injected from the hole injecting layer to the emissive layer. The material used for the hole transport layer preferably has appropriate ionization potential and hole mobility. More particularly, a triphenylamine derivative, N,N'-Bis(1-naphthyl)-N,N'-Diphenyl-1,1'-biphenyl-4,4'-diamine (NPD), N,N'-Diphenyl-N,N'-Bis[N-phenyl-N-(2-naphthyl)-4'-aminobiphenyl-4-yl]-1,1'-biphenyl-4,4'-diamine (NPTE), 1,1'-bis[(di-4-tolylamino)phenyl]cyclohexane (HTM2), and N,N'-Diphenyl-N,N'-Bis(3-methylphenyl)-1,1'-diphenyl-4,4'-diamine (TPD), or the like may preferably be used for the hole transport layer. The thickness of the hole transport layer is preferably 10 nm to 1000 nm. The thinner the hole transport layer, the lower the applied voltage may be, however, from a viewpoint of avoiding the problem of short-circuiting of the electrodes, the thickness of the hole transport layer is preferably 50 nm to 500 nm.

<Emissive Layer>

The emissive layer provides a location where recombination of the injected electrons and holes occurs, and a material used therefor preferably has a high emission efficiency. More particularly, an emissive host material and a doping material of emissive dye that are used for the emissive layer function as a recombination center of the holes and electrons injected from the anode and the cathode. Doping of the emissive dye to the host material forming the emissive layer enables a high emission efficiency to be obtained, and also converts an emission wavelength. These materials preferably have an appropriate energy level for injecting the charge, are chemically stable and have a superior heat resistance, to enable forming of an amorphous thin film having a uniform quality. In addition, these materials preferably have a large number of kinds of emissive colors, a superior color purity, and a high emission efficiency. Further, organic material used for the emission material includes low-molecular materials and high-molecular materials. In addition, the organic materials are categorized into fluorescent materials and phosphorescent materials depending on the emission mechanism. More particularly, the organic material forming the emissive layer includes, for example, a metal complex of quinoline derivative, such as tris(8-quinolinolate) aluminum complex (Alq$_3$), bis(8-hydroxy) quinaldine aluminum phenoxide (Alq'$_2$OPh), bis (8-hydroxy) quinaldine aluminum-2,5-dimethylphenoxide (BAlq), mono(2,2,6,6-tetramethyl-3,5-heptanedionate)lithium complex (Liq), mono(8-quinolinolate)sodium complex (Naq), mono(2,2,6,6-tetramethyl-3,5-heptanedionate) lithium complex, mono(2,2,6,6-tetramethyl-3,5-heptanedionate) sodium complex, bis(8-quinolinolate) calcium complex (Caq$_2$), or the like, and a fluorescent substance, such as tetraphenylbutadiene, phenylquinacridone (QD), anthracene, perylene, coronene, or the like. The host material is preferably a quinolinolate complex, and an aluminum complex having 8-quinolinol and a derivative thereof as a ligand is particular preferable.

<Electron Transport Layer>

The electron transport layer has a function to transport the electrons injected from the electrode. The material used for the electron transport layer includes, for example, a quinolinol aluminum complex (Alq$_3$), an oxadiazole derivative (for example, 2,5-bis(1-naphthyl)-1,3,4-oxadiazole (BND), 2-(4-t-butylphenyl)-5-(4-biphenyl)-1,3,4-oxadiazole (PBD) etc.), a triazole derivative, a bathophenanthroline derivative, a silole derivative, or the like.

<Electron Injecting Layer>

A material used for the electron injecting layer preferably increases the electron injection efficiency. The electron injecting layer may be a layer doped with an alkali metal such as lithium (Li), cesium (Cs), or the like to the cathode interface, for example.

In addition, the organic LED element in this embodiment may be formed on the substrate 21 as described above, and the substrate 21 may have a structure further provided with a light extracting layer. By providing the light extracting layer, it is possible to increase a light extraction efficiency from the organic LED element. The light extracting layer may be provided on the substrate 21, and is preferably provided on a surface opposing the first electrode 22.

A structure of the light extracting layer is not limited to a particular structure, and for example, may be formed by a scattering layer, a diffraction grating, or the like. It is particularly preferable to provide the scattering layer as the light extracting layer. A description will hereunder be given of examples of the structure of the scattering layer.

<Scattering Layer>

The scattering layer may be formed by forming glass powder on the substrate by a method such as coating or the like, and sintering at a desired temperature. Because the organic LED element in this embodiment can be formed without heating, as will be described later, the scattering layer may also be formed by a resin.

Particular examples of the structure of the scattering layer will be described hereunder.

The scattering layer may have a structure including a base material having a first refractive index, and a plurality of scattering substances dispersed within the base material and having a second refractive index different from that of the base material. A distribution of the scattering substances within the scattering layer preferably becomes smaller from an inside towards an outer surface of the scattering layer. By employing such a structure, it is possible to obtain a superior scattering characteristic while maintaining surface smoothness, and an extremely high light extraction efficiency can be achieved by using the structure on an emission surface side of a light emitting device or the like.

For example, a material (base material) having a high light transmittance and a coated principal surface may be used for the scattering layer. Glass, glass ceramics, translucent resins, and translucent ceramics, for example, may be used for the base material. The glass material includes inorganic glass such as soda lime glass, borosilicate glass, alkalifree glass, quartz glass, or the like. In addition, the translucent resins include polystyrene resins, polyester resins, cellulose resins, polyether resins, vinyl chloride resins, vinyl acetate resins, vinyl chloride co vinyl acetate resins, polyacrylic resins, polymethacrylate resins, polyolefin resins, urethane resins, silicone resins, imide resins, or the like, for example. The plurality of scattering substances (for example, bubbles, precipitating crystals, particles of material other than the base material, and phase-separated glass) are formed inside the base material. Here, the particles refer to small solid substances, typified by fillers and ceramics, for example. In addition, bubbles refer to air or gas matter. Further, phase-separated glass refers to glass formed by 2 or more kinds of glass phases. In a case in which the scattering substances are bubbles, a diameter of the scattering substances refer to a length of voids.

In order to improve the light extraction efficiency, the reactive index of the base material is preferably the same as or higher than the refractive index of the material forming the first electrode. This is because, in a case in which the refractive index of the base material is lower than the refractive index of the the first electrode material, a loss caused by total reflection is generated at an interface between the base material and the first electrode material. The refractive index of the base material need only be higher than the refractive index of the first electrode material in at least a part (for example, red, blue, green, etc.) of an emission'spectrum range of the emissive layer. The refractive index of the base material is preferably higher than that of the first electrode material throughout the entire emission spectrum range (430 nm to 650 nm), and more preferably higher than that of the first electrode material throughout the entire wavelength region of visible light.

In addition, in order to prevent a short-circuit between the electrodes of the organic LED element, it is preferable that the principal surface of the scattering layer (surface opposing the first electrode) is smooth. For this reason, it is not preferable for the scattering substances to project from the principal surface of the scattering layer. The scattering substances preferably exist 0.2 $\mu$m or less from the principal surface of the scattering layer so that the scattering substances do not project from the principal surface of the scattering layer. More particularly, an arithmetic average roughness (Ra) prescribed by JIS B0601-1994 for the principal surface of the scattering layer is preferably 30 nm or less, preferably 10 nm or less, and particularly more preferably 1 nm or less. The refractive index of the scattering substances and the refractive index of the base material may both be high, however, a difference ($\Delta$n) between the refractive indexes is preferably 0.2 or greater in at least a part of the emission spectrum range of the emissive layer. In order to obtain a sufficient scattering characteristic, the difference ($\Delta$n) between the refractive indexes is more preferably 0.2 or greater throughout the entire emission spectrum range (430 nm to 650 nm), or throughout the entire wavelength region (360 nm to 830 nm) of the visible light.

In order to obtain a maximum difference between the refractive indexes, the base material is preferably glass having a high refractive index, and the scattering substances are preferably gas matter, that is, bubbles, for example. Components of the glass having the high refractive index preferably includes a network former having one kind of component or two or more kinds of components selected from $P_2O_5$, $SiO_2$, $B_2O_3$, $Ge_2O$, and $TeO_2$, and a high-refractive-index component having one kind of component or two or more kinds of components selected from $TiO_2$, $Nb_2O_3$, $WO_3$, $Bi_2O_3$, $La_2O_3$, $Gd_2O_3$, $Y_2O_3$, $ZrO_2$, ZnO, BaO, PbO, and $Sb_2O_3$. From a viewpoint of adjusting the characteristic of glass, alkali oxides, alkali earth oxides, fluorides, or the like may be used within a range that does not deteriorate the properties required with regard to the refractive index. Particular examples of the glass system include $B_2O_3$-ZnO-$La_2O_3$, $P_2O_5$-$B_2O_3$-$R'_2$O-$R''$O-$TiO_2$-$Nb_2O_5$-$WO_3$-$Bi_2O_3$, $TeO_2$-ZnO, $B_2O_3$-$Bi_2O_3$, $SiO_2$-$Bi_2O_3$, $SiO_2$-ZnO, $B_2O_3$-ZnO, $P_2O_5$-ZnO, or the like, where R' denotes an alkali metal element and R'' denotes an earth metal element. The particular examples above are merely examples, and other structures may be used and the examples are not limited to the above, as long as the conditions described above are satisfied.

By causing the base material to have a specific transmittance spectrum, a tint of the emission can be varied. Transition metal oxides, rare earth metal oxides, metal colloids, or the like that are known may be used independently or in combination as a tint material.

In the organic LED element in this embodiment, a fluorescent substance may be used for the scattering substances or the base material. For this reason, it is possible to obtain the effect of varying the tint by performing the wavelength conversion by the emission from the organic layer. In this case, it is possible to reduce the emission colors of the organic LED element. In addition, because the light is scattered and emitted, it is possible to suppress an angle dependency of the tint and the change in the tint with the lapse of time.

Next, a description will be given of an example of the method of manufacturing the organic LED element in this embodiment.

The organic LED element in this embodiment can be manufactured by steps described hereunder.

The method of manufacturing the organic LED element in which the plurality of light emitting regions are connected in series preferably includes a first electrode forming step to form the first electrode, a barrier layer forming step to form the barrier layer, and a second electrode forming step to form the second electrode. At least during a time from a start of the first electrode forming step to an end of the barrier layer forming step, or during a time from a start of the barrier layer forming step to an end of the second electrode forming step, each step is preferably carried out under an atmosphere in which the C concentration is $5.0 \times 10^{21}$ atoms/m$^3$ or lower.

More particularly, each step is preferably carried out under the atmosphere in which the C concentration is $5.0 \times 10^{21}$ atoms/m$^3$ or lower during the time from the start of the first electrode forming step to the end of the barrier layer forming step and the second electrode forming step.

Conventionally, a known structure of the organic LED element includes a transparent electrode, auxiliary wirings, and a metal electrode. When manufacturing the organic LED element having this known structure, after depositing and patterning an ITO layer as the transparent electrode, stacked layers of the auxiliary wirings are deposited on the entire surface of the ITO layer. After patterning the stacked layers, the method of manufacturing the organic LED element deposits and forms the organic layer and the metal electrode that forms the cathode (as in Japanese Patent No. 3649238, for example).

In the conventional method of manufacturing the organic LED element, the auxiliary wirings and the metal electrode, for example, are not deposited continuously, and an exposure to the atmosphere generally takes place once. When the exposure to the atmosphere or the like including a predetermined amount or more of C (carbon) takes place during the steps of stacking the plurality of electrodes and the wirings, the C may adhere to an interface between the electrodes or to an interface between the electrode and the wiring. When the C adheres to the interface between the electrodes or to the interface between the electrode and the wiring, a contact resistance rises at such interfaces, and heat may be generated in a vicinity of such interfaces. For example, the amount of current supplied when an organic EL display element such as that proposed in Japanese Patent No. 3649238 referred above is in use is small, and because the current is supplied in the form of pulses, the rise in the contact resistance at the interface between the electrodes and at the interface between the electrode and the wiring, and the heat generated at these interface parts, are unlikely to introduce problems.

On the other hand, particularly for use in lighting which is one of the usages of the organic LED element in this embodiment, a large current is continuously supplied to the organic LED element. For this reason, it is more important to reduce the resistance between the first electrode and the second electrode and to further reduce the contact resistance between the first electrode and the barrier layer or between the barrier layer and the second electrode, when compared to the organic EL display element.

Hence, in the organic LED element in this embodiment, the barrier layer is provided between the first electrode and the second electrode. In addition, in order to obtain a state in which the amount of C (carbon) at the interface between the first electrode and the barrier layer or the barrier layer and the second electrode is small, each step is preferably carried out under an atmosphere in which the C concentration is $5.0 \times 10^{21}$ atoms/m$^3$ or lower, at least during a time from a start of the first electrode forming step to an end of the barrier layer forming step, or during a time from a start of the barrier layer forming step to an end of the second electrode forming step. Moreover, the C concentration in this atmosphere is more preferably $5.0 \times 10^{18}$ atoms/m$^3$ or lower, and particularly more preferably $3.0 \times 10^{16}$ atoms/m$^3$ or lower.

A method of measuring the C concentration within the atmosphere is not limited to a particular method, and the C concentration may be measured by a residual gas spectrometer provided with a mass spectrometer, a Fourier Transform Infra-Red (FTIR) spectrophotometer for gas analysis, or the like.

A Quadrupole mass (Q-mass) spectrometer is popularly used as the mass spectrometer for making the residual gas analysis within the atmosphere. This mass spectrometer is provided with an ionizer that causes electrons to collide in order to ionize gas molecules, a mass separator that separates the generated ions according to a mass-to-charge ratio of the ions, and an analyzer that detects the separated ions. A quadrupole field can be generated by superimposing a direct current voltage and an alternating current voltage to 4 rod-shaped poles that are arranged in parallel so that respective center axes thereof coincide with vertexes of a square.

The FTIR spectrophotometry can obtain each gas concentration by causing infrared light to pass through a sample gas and measuring an absorbance thereof.

By introducing a part of the atmosphere gas into a manufacturing apparatus of the organic LED element and performing a measurement by the above residual gas spectrometer provided with the mass spectrometer, or the above FTIR spectrophotometer for gas analysis, it is possible to measure, in real-time, the C concentration within the atmosphere at each layer forming step.

By manufacturing the organic LED element by this manufacturing method, the C concentration at the interface region between the first electrode or the second electrode and the barrier layer can be reduced, and the contact resistance at the interface region can also be reduced. In addition, it is possible to suppress a voltage rise caused by aging or powering. For this reason, it is possible to manufacture an organic LED element that can be applied for lighting use, for example, and particularly capable of high-intensity lighting by being applied with a large current.

In the manufacturing method of the organic LED element in this embodiment, the atmosphere simply needs to be controlled so that the C concentration is $5.0 \times 10^{21}$ atoms/m$^3$ or lower, during the time from the start of the first electrode forming step to the end of the barrier layer forming step, or during the time from the start of the barrier layer forming step to the end of the second electrode forming step. For this reason, the atmosphere may be modified according to the conditions at the time when the first electrode, the second electrode, and the barrier layers are formed. However, when the conditions are modified, a number of operations increases to deteriorate productivity, and impurities may become mixed when modifying the atmosphere. Hence, it is preferable that the atmosphere is the same during the time from the start of the first electrode forming step to the end of the barrier layer forming step and the second electrode forming step. More particularly, each step is preferably carried out in a vacuum atmosphere or an inert gas atmosphere including nitrogen, argon, helium, or the like, for example. It is particularly preferable to carry out each step in the vacuum atmosphere.

Because the organic LED element in this embodiment has the series-connected structure, the first electrode may have a somewhat high resistance. For this reason, in a case in which steps at least during the time from the start of the first electrode forming step to the end of the barrier layer forming step, or during the time from the start of the barrier layer forming step to the end of the second electrode forming step are carried out in the vacuum atmosphere, it is possible to employ a transparent electrode material that can be formed by room temperature deposition when forming the first electrode. The first electrode having an appropriate resistance characteristic can be produced under the vacuum atmosphere, without generating inconveniences such as crystallization of the material forming the first electrode or the like, because no high-temperature process is carried out. In addition, because no heating is required at the time of depositing the transparent electrode, it is unnecessary to provide a step to cool the substrate before forming the organic layer, and an efficient production can be achieved.

Each structure of the first electrode, the second electrode, and the barrier is as described above. It is particularly preferable that the barrier layer is formed by a metal or an alloy including one or more elements selected from Cr, Mo, Ti, Ta, Pd, and Pt. From a viewpoint of cost or the like, it is more preferable that the barrier layer is formed by a metal selected from Cr and Mo, or an alloy of the metal selected from Cr and Mo. Examples of the alloy of the metal selected from Cr and Mo include NiMo, MoNb, or the like, for example.

Methods of forming the first electrode, the second electrode, and the barrier layer are not limited to particular methods, and it is possible to employ various manufacturing methods that can be performed in the atmosphere described above. For example, a deposition method using masks may be preferably used for the manufacturing method. More particularly, it is preferable that, after arranging masks having predetermined shapes (openings) according to shapes of the first electrode, the second electrode, and the barrier layer, the first electrode, the second electrode, and the barrier layer are respectively formed by sputtering, deposition, CVD, or the like.

An order in which the second electrode forming step and the barrier layer forming step are carried out is not limited to a particular order, and may be selected arbitrarily according to the structure of the organic LED element that is formed. For example, in the case of the organic LED element illustrated in FIG. 2 (A), it is preferable to carry out the first electrode forming step, thereafter carry out the barrier layer forming step, and thereafter carry out the second electrode layer forming step. In addition, in the case of the organic LED element illustrated in FIG. 2(B), it is preferable to carry out the first electrode forming step, thereafter carry out the second electrode forming step, and thereafter carry out the barrier layer forming step.

An arbitrary step may be provided in addition to the first electrode forming step, the barrier layer forming step, and the second electrode forming step described above.

For example, a light emitting part forming step may be carried out between the barrier layer forming step and the second electrode forming step. The light emitting part may have the structure described above. A method of forming the light emitting part in the light emitting part forming step is not limited to a particular method, and for example, may preferably be a deposition using a mask, similarly as in the case of forming the first electrode or the like, and form the light emitting part by sputtering, deposition, CVD, or the like.

In addition, in the case in which the organic LED element is formed on the substrate and the substrate is provided with the light extracting layer as described above, a light extracting layer forming step may be provided. In this case, the light extracting layer is not limited to a particular structure, and may be provided with a diffraction grating or a scattering layer, for example. Because the light extracting layer forming step is carried out before the first electrode forming step, an atmosphere in which the light extracting layer forming step is carried out is not limited to a particular atmosphere, and the light extracting layer forming step may be carried out in an arbitrary atmosphere.

According to the manufacturing method of the organic LED element in this embodiment described heretofore, it is possible to suppress the rise in the contact resistance between the first electrode and the barrier layer, or between the barrier layer and the second electrode, forming the organic LED element. For this reason, even in the usages such as for use in lighting where the large current is continuously supplied, for example, it is possible to suppress the generation of heat between each electrode and the barrier layer, and to prevent breakdown of the organic LED element.

[Second Embodiment]

A description will be given of the structure of the organic LED element in this embodiment.

The organic LED element in this embodiment includes a plurality of light emitting regions connected in series. The light emitting region includes the first electrode 22 and the second electrode 24. Between two adjacent light emitting regions, the first electrode 22 of one light emitting region and the second electrode 24 of the other light emitting region are connected via the barrier layer 25. The O concentration in the interface region between the second electrode 24 and the barrier layer 25 is preferably 20 atomic % or lower.

In a case in which a predetermined amount of oxygen exists in the interface region between the second electrode 24 and the barrier layer 25, the oxygen may diffuse to the second electrode 24 and increase the resistance value. On the other hand, in the organic LED element in this embodiment, the O concentration in the interface region between the second electrode 24 and the barrier layer 25 is 20 atomic % or lower and low, and thus, it is possible to suppress a rise in the resistance value in a vicinity of the interface region. The O (oxygen) concentration in the interface region between the second electrode 24 and the barrier layer 25 is preferably 10 atomic % or lower, more preferably 7 atomic % or lower, and particularly more preferably 5 atomic % or lower.

The organic LED element in this embodiment may have a structure similar to that of the organic LED element in the first embodiment described above, and each member may have a structure similar to that in the first embodiment. Hence, a description of the structure and each member in this embodiment will be omitted. Further, the interface regions in this embodiment may be similar to those in the first embodiment, and a description thereof will be omitted. In the organic LED element in this embodiment, the interface region between the first electrode 22 and the barrier layer 25 may have a structure including a compatible layer. In addition, the interface region between the second electrode layer 24 and the barrier layer 25 may have a structure including a compatible layer.

The method of measuring the O concentration is not limited to a particular method, and an arbitrary method may be employed for the measurement. For example, the measurement may be made by a TEM (Transmission Electron Microscope), an XPS (X-ray Photo-electron Spectroscopy), an RBS (Rutherford Back-scattering Spectroscopy), an ERDA (Elastic Recoil Detection Analysis), or the like.

A description will be given of a particular example in which the O concentration is measured by the XPS. The C concentration may be measured by a similar procedure, and similar measurements and evaluation may be performed with respect to the organic LED element in the first embodiment.

The method of obtaining the O concentration by the XPS can perform the elemental analysis in a depth direction of the stacked layers including the first electrode, the barrier layer, and the second electrode, by repeating etching of a sample by Ar+ ion sputtering and performing an XPS measurement of the sample surface after the etching, for example.

$Ar^+$ ions accelerated to 2 kV, for example, scan within a region of 2 mm square for 1 minute to etch the sample, and an elemental analysis is performed on the sample surface after the etching using the XPS. An element profile in the depth direction is obtained by alternately repeating this procedure. In the case in which the second electrode 24 is Al, the Al that is a main constituent element is initially detected on the side of the second electrode 24, however, in a vicinity of the interface 51 with the barrier layer 25, the detection intensity of Al gradually decreases, and the detection intensity of Mo, for example, that is a main constituent element of the barrier layer 25 gradually increases. Since mixing occurs on the sample surface by the $Ar^+$ ion irradiation, and the detection depth of the XPS determined by an inelastic mean free path of the electrodes within the sample is several nm, the detection intensity of each element observed at the interface 51 between the second electrode and the barrier layer gradually changes. The depth at which the Al that is the main constituent element within the second electrode decreases to 1/2 may be regarded as the interface 51 between the second electrode and the barrier layer, and a width $\Delta Z$ of the depth where the Al detection intensity becomes 84% that of the second electrode and the depth where the Al detection intensity becomes 16% that of the second electrode is defined as a depth resolution. By appropriately selecting etching conditions of the $Ar^+$ ions, $\Delta Z$ can be set to 30 nm or less, and may further be set to 10 nm or less that corresponds to the depth of the interface region by optimizing the etching conditions.

A description is given above with respect to the interface region between the second electrode 24 and the barrier layer 25 as an example. However, the O concentration may be computed using the XPS in a similar matter, with respect to the interface region between the first electrode 22 and the barrier layer 25.

As will be described later, in the method of manufacturing the organic LED element in this embodiment, each step is preferably carried out under an atmosphere in which the O concentration is $5.0 \times 10^{24}$ atoms/m$^3$ or lower during the time from the start of the barrier layer forming step to the end of the second electrode forming step. However, in a case in which the barrier layer after being formed is placed in an atmosphere in which the oxygen concentration is approximately $1.1 \times 10^{25}$ atoms/m$^2$, for example, and the second electrode is formed thereafter, a location where the O (oxygen) concentration is higher than other parts is detected in a region having a width within 10 nm with reference to the interface 51, that is regarded as a center, between the second electrode and the barrier layer, that is, detected in the interface region 52. In a case in which the 0 (oxygen) concentration is measured by the XPS with respect to the interface region 52, the 0 (oxygen) concentration may be observed as 25 atomic %, for example. In the case of the organic LED element in this embodiment, the 0 (oxygen) concentration in the interface region that is measured in the above described manner is preferably 20 atomic % or lower, as already described above. The O concentration may be the same for cases in which the TEM and an EDX are used for the measurement.

In addition, in the stacked layers including the first electrode, the barrier layer, and the second electrode, each layer and each interface may be directly observed at the atomic level, by making a slice sample including a cross section of the stacked layers and performing the TEM observation. In this case, the elemental analysis may also be performed by the EDX (Energy Dispersive X-ray spectroscopy). The region in which the observation and the analysis are performed is limited to the size of the slice sample, however, this is an effective method of observing and analyzing the layer interface with a high resolution. In this case, not only the 0 concentration but also the C concentration may be measured with respect to the interface region. For this reason, the measurement and evaluation may similarly applied with respect to the organic LED element in the first embodiment.

In the case in which the barrier layer after being formed is placed in an atmosphere in which the oxygen concentration is approximately $1.1 \times 10^{25}$ atoms/m$^2$, for example, the second electrode is formed thereafter, and the O (oxygen) concentration is measured with respect to the interface region 52 using the TEM and the EDX, the O (oxygen) concentration may be observed as 25 atomic %, for example.

A description is given heretofore of examples of the analysis for the case in which the interface clearly exists between the barrier layer 25 and the first electrode 22 or the second electrode 24. However, the analysis may be performed in a similar manner in a case in which the compatible layer 53 is observed at the interface between the barrier layer 25 and the first electrode 22 or the second electrode 24.

A description will be given of an example of a case in which the barrier layer 25 after being formed is placed in an atmosphere in which the oxygen concentration is approximately $1.1 \times 10^{25}$ atoms/m$^2$, the second electrode is formed thereafter, and the compatible layer 53 is formed between the barrier layer 25 and the second electrode 24.

In this case, when the elemental analysis is performed in a manner similar to the above with respect to the interface region using the XPS, the TEM, and the EDX, there are cases in which the constituent elements of both the barrier layer 25 and the second electrode 24 are detected in the compatible layer 53. In the compatible layer 53, in addition to the constituent element of the barrier layer 25 or the like, it is possible to detect 0 having a concentration (for example, O concentration of 25 atomic %) higher than that within the barrier layer 25.

Accordingly, even in the case in which the compatible layer 53 exists, when a part having a high O concentration exists in a vicinity of the interface, the elemental analysis can detect the constituent element of the barrier layer 25, also the constituent element of the second electrode 24 in some cases, and an 0 concentration (for example, 0 concentration of 25 atomic %) that is higher than that at other parts, in a part of the compatible layer 53 or in the entire compatible layer 53. The thickness of the compatible layer 53 is normally approximately 10 nm to 20 nm. In addition, in the case of the organic LED element in this embodiment, even in the case in which the compatible layer 53 is observed at the interface between the barrier layer 25 and the first electrode 22 or the second electrode 24, it is preferable that the 0 (oxygen) concentration in the interface region is 20 atomic % or lower, as already described above.

Next, a description will be given of the method of manufacturing the organic LED element in this embodiment.

The organic LED element in this embodiment can be manufactured by steps described hereunder.

The method of manufacturing the organic LED element in which the plurality of light emitting regions are connected in series includes a first electrode forming step to form the first electrode, a barrier layer forming step to form the barrier layer, and a second electrode forming step to form the second electrode.

At least during a time from a start of the first electrode forming step to an end of the barrier layer forming step, or during a time from a start of the barrier layer forming step to an end of the second electrode forming step, each step is preferably carried out under an atmosphere in which the O concentration is $5.0 \times 10^{24}$ atoms/m$^3$ or lower.

More particularly, each step is preferably carried out under the atmosphere in which the C concentration is $5.0 \times 10^{24}$ atoms/m$^3$ or lower during the time from the start of the first electrode forming step to the end of the barrier layer forming step and the second electrode forming step.

Moreover, the O concentration within this atmosphere is more preferably $5.0 \times 10^{21}$ atoms/m$^3$ or lower, and

particularly more preferably 3.0 x $10^{19}$ atoms/m$^3$ or lower.

The method of measuring the O concentration within the atmosphere is not limited to a particular method, and the O concentration may be measured by a residual gas spectrometer provided with a mass spectrometer, a Fourier Transform Infra-Red (FTIR) spectrophotometer for gas analysis, or the like.

In the manufacturing method of the organic LED element in this embodiment, the atmosphere simply needs to be controlled so that the O concentration is $5.0 \times 10^{24}$ atoms/m$^3$ or lower, during the time from the start of the first electrode forming step to the end of the barrier layer forming step, or during the time from the start of the barrier layer forming step to the end of the second electrode forming step. For this reason, the atmosphere may be modified according to the conditions at the time when the first electrode, the second electrode, and the barrier layers are formed. However, when the conditions are modified, a number of operations increases to deteriorate productivity, and impurities may become mixed when modifying the atmosphere. Hence, it is preferable that the atmosphere is the same during the time from the start of the first electrode forming step to the end of the barrier layer forming step and the second electrode forming step. More particularly, each step is preferably carried out in a vacuum atmosphere or an inert gas atmosphere including nitrogen, argon, helium, or the like, for example. It is particularly preferable to carry out each step in the vacuum atmosphere.

The structures of the first electrode, the barrier layer, and the second electrode, and the particular method of manufacturing these layers, may be similar to those of the method of fabricating the organic LED element in the first embodiment, except for the O concentration within the atmosphere, and a description thereof will be omitted.

Similarly as in the case of the method of manufacturing the organic LED element in the first embodiment, an order in which the second electrode forming step and the barrier layer forming step are carried out in the method of manufacturing the organic LED element in this embodiment is not limited to a particular order, and may be selected arbitrarily according to the structure of the organic LED element that is formed.

In the method of manufacturing the organic LED element in this embodiment, it is also possible to provide various arbitrary steps, such as a light emitting part forming step, a light extracting layer forming step, or the like, in addition to the first electrode forming step, the barrier layer forming step, and the second electrode forming step described above.

According to the method of manufacturing the organic LED element in this embodiment described heretofore, it is possible to reduce the 0 (oxygen) concentration included in the interface region between the first electrode and the barrier layer, or in the interface region between the barrier layer and the second electrode. For this reason, it is possible to particularly suppress the rise in the contact resistance between the barrier layer and the second electrode caused by the oxygen diffusing to the second electrode that is formed by the metal electrode, for example.

In addition, in the method of manufacturing the organic LED element in this embodiment, at least during the time from the start of the first electrode forming step to the end of the barrier layer forming step, or during the time from the start of the barrier layer forming step to the end of the second electrode forming step, each step is preferably carried out under an atmosphere in which the C concentration is $5.0 \times 10^{21}$ atoms/m$^3$ or lower. Moreover, the C concentration in this atmosphere is more preferably 5.0 x $10^{18}$ atoms/m$^3$ or lower, and particularly more preferably 3.0 x $10^{16}$ atoms/m$^3$ or lower.

Accordingly, it is possible to reduce both the O (oxygen) concentration and the C (carbon) concentration included in the interface region between the first electrode and the barrier layer, and the interface region between the barrier layer and the second electrode. For this reason, in a case in which the second electrode is formed by a metal, for example, it is possible to more effectively suppress the rise in the resistance between the barrier layer and the second electrode.

The atmosphere during the time from the start of the first electrode forming step to the end of the barrier layer forming step, or during the time from the start of the barrier layer forming step to the end of the second electrode forming step, is not limited to a particular atmosphere as long as the C concentration is 5.0 x $10^{21}$ atoms/m$^3$ or lower and the 0 concentration is 5.0 x $10^{24}$ atoms/m$^3$ or lower, and this embodiment may be selected according to the conditions at the time when the first electrode, the second electrode, and the barrier layers are formed. However, when the conditions are modified, a number of operations increases to deteriorate productivity, and impurities may become mixed when modifying the atmosphere. Hence, it is preferable that the atmosphere is the same during the time from the start of the first electrode forming step to the end of the barrier layer forming step and the second electrode forming step. More particularly, each step is preferably carried out in a vacuum atmosphere or an inert gas atmosphere including nitrogen, argon, helium, or the like, for example. It is particularly preferable to carry out each step in the vacuum atmosphere.

[Third Embodiment]

A description will be given of an example of the structure of the organic LED element in this embodiment.

The organic LED element in this embodiment includes a plurality of light emitting regions connected in series. The light emitting region includes the first electrode 22 and the second electrode 24. Between two adjacent light emitting regions, the first electrode 22 of one light emitting region and the second electrode 24 of the other light emitting region are connected via the barrier layer 25. An H concentration in the interface region between the first electrode 22 and the barrier layer 25, or in the interface region between the second electrode 24 and the barrier layer 25, is 5 atomic % or lower.

The H (hydrogen) concentration in the interface region between the first electrode 22 and the barrier layer 25, or in the interface region between the second electrode 24 and the barrier layer 25, is mainly caused by moisture existing in these interface regions. For this reason, in a case in which a predetermined amount or more of H (hydrogen) is detected in these interface regions, it may be regarded that moisture exists in these regions. In this case, the moisture is not preferable in that the moisture may act to deteriorate a reliability of an electrical connection between the first electrode 22 and the barrier layer 22, and between the barrier layer 25 and the second electrode 24. Hence, it is preferable that the H concentration is 5 atomic % or lower in the interface region between the first electrode 22 and the barrier layer 25, or in the interface region between the second electrode 24 and the barrier layer 25. It is particularly preferable that the H concentration in these interface regions is 3 atomic % or lower.

In the organic LED element in this embodiment, the H concentration in the interface region between the first electrode 22 and the barrier layer 25, and in the interface region between the second electrode 24 and the barrier layer 25, is preferably 5 atomic % or lower, and more preferably 3 atomic % or lower.

The organic LED element in this embodiment may have a structure similar to those of the organic LED elements of the first embodiment and the second embodiment described above, and each member member may have a structure similar to those in the first and second embodiments. Hence, a description of the structure and each member in this embodiment will be omitted. Further, the interface regions in this embodiment may be similar to those in the first and second embodiments, and a description thereof will be omitted. In the organic LED element in this embodiment, the interface region between the first electrode 22 and the barrier layer 25 may have a structure including a compatible layer. In addition, the interface region between the second electrode layer 24 and the barrier layer 25 may have a structure including a compatible layer.

A distribution in the depth direction of the H concentration included in the stacked layers including the first electrode, the barrier layer, and the second electrode may be measured by ERDA (Elastic Recoil Detection Analysis). This method injects He$^+$ ions to a sample, detects H atoms (recoil H particles) that are ejected frontwards by elastic scattering, and obtains the distribution of the H concentration in the depth direction by varying an energy of the He$^+$ ions that are injected. This method injects the He$^+$ ions having a small atomic radius, and utilizes the elastic scattering of He$^+$ and the atoms within the sample, and performs a quantitative analysis (non-destructive analysis) that does not cause destruction of the sample.

In a case in which the barrier layer, after being formed, is extracted from a vacuum deposition apparatus, for example, placed in an atmospheric environment, and thereafter introduced again into the vacuum deposition apparatus and the second electrode is formed, a profile is obtained in which a location where the H concentration is higher than other parts exists in a region having a width within 10 nm with reference to the interface, that is regarded as a center, between the second electrode and the barrier layer, that is, exists in the interface region. For example, the H concentration in the interface region is observed as 10 atomic %. In the case of the organic LED element in this embodiment, the measured H (hydrogen) concentration in the interface region is preferably 5 atomic % or lower, and more preferably 3 atomic % or lower, as already described above.

Next, a description will be given of the method of manufacturing the organic LED element in this embodiment.

The organic LED element in this embodiment can be manufactured by steps described hereunder.

The method of manufacturing the organic LED element in which the plurality of light emitting regions are connected in series includes a first electrode forming step to form the first electrode, a barrier layer forming step to form the barrier layer, and a second electrode forming step to form the second electrode.

At least during a time from a start of the first electrode forming step to an end of the barrier layer forming step, or during a time from a start of the barrier layer forming step to an end of the second electrode forming step, each step is preferably carried out under an atmosphere in which the H concentration is 5.0 x 10$^{22}$ atoms/m$^3$ or lower.

More particularly, each step is preferably carried out under the atmosphere in which the H concentration is 5.0 x 10$^{22}$ atoms/m$^3$ or lower during the time from the start of the first electrode forming step to the end of the barrier layer forming step and the second electrode forming step.

Moreover, the H concentration within this atmosphere is more preferably 2.0 x 10$^{22}$ atoms/m$^3$ or lower, and particularly more preferably 3.0 x 10$^{20}$ atoms/m$^3$ or lower.

The method of measuring the H concentration within the atmosphere is not limited to a particular method, and an arbitrary method may be used. The H concentration of the atmosphere may be measured by a residual gas spectrometer provided with a mass spectrometer, a Fourier Transform Infra-Red (FTIR) spectrophotometer for gas analysis, or the like.

In the manufacturing method of the organic LED element in this embodiment, the atmosphere simply needs to be controlled so that the H concentration is $5.0 \times 10^{22}$ atoms/m$^3$ or lower, during the time from the start of the first electrode forming step to the end of the barrier layer forming step, or during the time from the start of the barrier layer forming step to the end of the second electrode forming step. For this reason, the atmosphere may be modified according to the conditions at the time when the first electrode, the second electrode, and the barrier layers are formed. However, when the conditions are modified, a number of operations increases to deteriorate productivity, and impurities may become mixed when modifying the atmosphere. Hence, it is preferable that the atmosphere is the same during the time from the start of the first electrode forming step to the end of the barrier layer forming step and the second electrode forming step. More particularly, each step is preferably carried out in a vacuum atmosphere or an inert gas atmosphere including nitrogen, argon, helium, or the like, for example. It is particularly preferable to carry out each step in the vacuum atmosphere.

The structures of the first electrode, the barrier layer, and the second electrode, and the particular method of manufacturing these layers, may be similar to those of the method of fabricating the organic LED element in the first embodiment, except for the H concentration within the atmosphere, and a description thereof will be omitted.

Similarly as in the case of the method of manufacturing the organic LED element in the first embodiment, an order in which the second electrode forming step and the barrier layer forming step are carried out in the method of manufacturing the organic LED element in this embodiment is not limited to a particular order, and may be selected arbitrarily according to the structure of the organic LED element that is formed.

In the method of manufacturing the organic LED element in this embodiment, it is also possible to provide various arbitrary steps, such as a light emitting part forming step, a light extracting layer forming step, or the like, in addition to the first electrode forming step, the barrier layer forming step, and the second electrode forming step described above.

According to the method of manufacturing the organic LED element in this embodiment described heretofore, it is possible to reduce the hydrogen concentration included in the interface region between the first electrode and the barrier layer, or in the interface region between the barrier layer and the second electrode. For this reason, it is possible to particularly reduce the hydrogen concentration in each interface region, and secure the reliability of the electrical connection between the first electrode and the barrier layer, or between the barrier layer and the second electrode.

In addition, in the method of manufacturing the organic LED element in this embodiment, at least during the time from the start of the first electrode forming step to the end of the barrier layer forming step, or during the time from the start of the barrier layer forming step to the end of the second electrode forming step, each step may be carried out under an atmosphere in which the C concentration is $5.0 \times 10^{21}$ atoms/m$^3$ or lower. Moreover, the C concentration in this atmosphere is more preferably $5.0 \times 10^{18}$ atoms/m$^3$ or lower, and particularly more preferably $3.0 \times 10^{16}$ atoms/m$^3$ or lower.

Accordingly, it is possible to reduce both the H (hydrogen) concentration and the C (carbon) concentration included in the interface region between the first electrode and the barrier layer, and the interface region between the barrier layer and the second electrode. For this reason, it is possible to suppress the rise in the resistance, while securing the reliability of the electrical connection between the barrier layer and the first and second electrodes.

During the time from the start of the first electrode forming step to the end of the barrier layer forming step, or during the time from the start of the barrier layer forming step to the end of the second electrode forming step, each step is preferably carried out in an atmosphere in which the O concentration is $5.0 \times 10^{24}$ atoms/m$^3$ or lower. The O concentration in this atmosphere is more preferably $5.0 \times 10^{21}$ atoms/m$^3$ or lower, and particularly more preferably $3.0 \times 10^{19}$ atoms/m$^3$ or lower.

In this case, it is possible to suppress the rise in the resistance, while securing the reliability of the electrical connection between the barrier layer and the first and second electrodes.

The atmosphere during the time from the start of the first electrode forming step to the end of the barrier layer forming step, or during the time from the start of the barrier layer forming step to the end of the second electrode forming step, is not limited to a particular atmosphere as long as the C concentration in the atmosphere is $5.0 \times 10^{21}$ atoms/m$^3$ or lower, the O concentration in the atmosphere is $5.0 \times 10^{24}$ atoms/m$^3$ or lower in some cases, and and the H concentration in the atmosphere is $5.0 \times 10^{22}$ atoms/m$^3$ or lower. The atmosphere may be selected according to the conditions at the time when the first electrode, the second electrode, and the barrier layers are formed. However, when the conditions are modified, a number of operations increases to deteriorate productivity, and impurities may become mixed when modifying the atmosphere. Hence, it is preferable that the atmosphere is the same during the time from the start of the first electrode forming step to the end of the barrier layer forming step and the second electrode forming step. More particularly, each step is preferably carried out in a vacuum atmosphere or an inert gas atmosphere including nitrogen, argon, helium, or the like, for example. It is particularly preferable to carry out each step in the vacuum atmosphere.

Exemplary Implementations

Next, a description will be given of particular exemplary implementations, however, the present invention is not limited to such exemplary implementations.

[Reference Example 1]

The following experiment was conducted in order to investigate the relationship between the interface impurity concentration and the contact resistance.

In this reference example, a sample, including a part where the transparent electrode (first electrode) and the metal electrode (second electrode) are stacked on the glass substrate, was made. A plurality of kinds of the sample were made by varying the impurity concentration amongst the layers, by varying a state of preservation during the time after depositing the transparent electrode and before depositing the barrier layer, and during the time after depositing the barrier layer and before depositing the metal electrode.

The contact resistance, and the interface impurity concentration using the XPS were measured with respect to the obtained samples, and the relationship between the interface impurity concentration and the contact resistance was confirmed from evaluation results of the measurements.

First, a description will be given of the particular methods of making the samples and evaluating the samples.

(Structure of Samples)

A description will be given of the structure of the samples that are made, by referring to FIG. 6 (A) and (B).

FIG. 6 (A) illustrates a top view of the sample that is formed, that is, a diagram viewed from a direction perpendicular to a surface on which the transparent electrode or the like are arranged on the glass substrate. FIG. 6 (B) illustrates a cross sectional view of a line segment B in FIG. 6 (A).

First, a transparent electrode 62 was deposited on a clean glass substrate 61, as illustrated in FIG. 6 (A). The transparent electrode 62 was deposited in a line pattern, and a width W62 of the line pattern was set to 2.0 mm. The transparent electrode 62 was formed in the line pattern elongated in an X-axis direction, as illustrated in FIG. 6 (A), and was deposited at 2 locations on the glass substrate 61 with the same shape. The transparent electrode 62 was deposited by a DC magnetron sputtering apparatus (model: SLC-38S manufactured by Shimadzu Corporation), and the layer thickness of the transparent electrode 62 was 450 nm for each of the samples.

Next, as illustrated in FIG. 6 (A), a barrier layer 63 was deposited in a square pattern having a length W63 of one side set to 1.5 mm, within a region where a metal electrode which will be described later is stacked. The barrier layer 63 is covered by the metal electrode 64 which will be described later, and is not visible from the top surface side of the sample, and thus, the barrier layer 66 is illustrated by dotted lines in FIG. 6 (A). As illustrated in FIG. 6 (A), the barrier layer 63 is formed in each of the 2 regions where the metal electrode 64 which will be described later is stacked above the transparent electrode 62. In other words, the barrier layer is formed at 2 locations. The barrier layer 63 was deposited using a vacuum deposition apparatus (model: Try-ELVES020G manufactured by Tokki Corporation Ltd.), and the layer thickness of the deposited barrier layer 63 was 50 nm for each of the samples.

As will be described later, no barrier layer 63 was formed for sample No. 1-1-2 to sample No. 1-4-2, and the metal electrode 64 which will be described later was formed directly on the transparent electrode 62 to make contact therewith.

Further, the metal electrode 64 was deposited to cover the barrier layer 63. As illustrated in FIG. 6 (A), the metal electrode 64 was deposited in a line pattern, and a width W64 of the line pattern was set to 2.0 mm. The metal electrode 64 was formed in the line pattern elongated in a Y-axis direction, as illustrated in FIG. 6 (A), and was formed to connect the 2 transparent electrodes 62. The metal electrode 64 was deposited using the vacuum deposition apparatus (model: Try-ELVES020G manufactured by Tokki Corporation Ltd.), and the layer thickness of the metal electrode 64 was 80 nm for each of the samples.

The transparent electrode 62, the barrier layer 63, and the metal electrode 64 are all deposited to the shapes illustrated in FIG. 6 (A), using masks. The cross section of the line segment B in FIG. 6 (A) has a structure in which the 3 layers formed by the transparent electrode 62, the barrier layer 63, and the metal electrode 64 are stacked on the glass substrate 61 as illustrated in FIG. 6 (B) for sample No. 1-1-1 to sample No. 1-4-1. In addition, because no barrier layer 63 is formed for the sample No. 1-1-2 to sample No. 1-4-2, these samples have a structure in which the metal electrode 64 is stacked directly on the transparent electrode 62.

(Sample Making Conditions)

Particular conditions of making the samples are as follows.

First, ITO was used for the material of the transparent electrode 62, Cr was used for the material of the barrier layer 63, and Al was used for the material of the metal electrode 64, for each of the samples, to make the samples for measuring the contact resistance illustrated in FIG. 6 (A) and (B).

A description will be given of the conditions of making the sample No. 1-1-1 to sample No. 1-4-1.

As illustrated in Table 1, the sample No. 1-1-1 to sample No. 1-4-1 were made by depositing the ITO layer forming the transparent electrode 62, and thereafter carrying out a pure water ultrasonic cleaning and an oxygen plasma process before depositing the Cr layer forming the barrier layer 63.

The pure water ultrasonic cleaning dipped the sample in pure water, and was performed for 10 minutes using an ultrasonic cleaning apparatus (model: AUTO PURSE 1200·28F manufactured by Kaijo Corporation). In addition, the oxygen plasma process was performed for 7 minutes under an oxygen atmosphere using an oxygen plasma process apparatus (model: QUICK COATER SC-706 manufactured by Sanyu Electron Co. Ltd.).

Next, after depositing the Cr layer forming the barrier layer 63, each of the sample No. 1-1-1 to sample No. 1-4-1 were made in various states before the deposition of the Al layer forming the metal electrode 64, as illustrated in Table 1.

The sample No. 1-1-1 was made by depositing the barrier layer 63, and thereafter depositing the metal electrode 64 in a continuous manner within the same vacuum deposition apparatus. For this reason, the sample was maintained within a vacuum atmosphere of $10^{-4}$ Pa or lower, from the start of depositing the barrier layer 63 to the end of depositing the metal electrode 64. In other words, the sample No. 1-1-1 was made by maintaining the atmosphere from the start of depositing the barrier layer 63 to the end of depositing the metal electrode 64, so that the C concentration is $5.0 \times 10^{21}$ atoms/m$^3$ or lower, the O concentration is $5.0 \times 10^{24}$ atoms/m$^3$ or lower, and the H concentration is $5.0 \times 10^{22}$ atoms/m$^3$ or lower.

The sample No. 1-2-1 was made by depositing the barrier layer 63, and thereafter left to stand within a normal room, that is, in an atmospheric environment for 1 day, before depositing the metal electrode 64 using the vacuum deposition apparatus.

In addition, the sample No. 1-3-1 to sample No. 1-4-1 were made by depositing the barrier layer 63, and thereafter left to stand within a clean room, that is, in a clean atmospheric environment for 1 day, before performing a pure water ultrasonic cleaning under the same conditions as the pure water ultrasonic cleaning that was performed after depositing the transparent electrode 62. The sample No. 1-3-1 was made by simply depositing the metal electrode 64 using the vacuum deposition apparatus. The sample No. 1-4-1 was made by performing an oxygen plasma process under the same conditions as the oxygen plasma process that was performed after depositing the transparent electrode 62, and thereafter depositing the metal electrode 64 using the vacuum deposition apparatus.

A description will be given of the conditions of making the sample No. 1-1-2 to sample No. 1-4-2 for comparison purposes.

The sample No. 1-1-2 to sample No. 1-4-2 were made without providing the Cr layer forming the barrier layer 63, and directly forming the metal electrode 64 on the transparent electrode 62. Otherwise, these samples were made to have the same structure as the sample illustrated in FIG. 6 (A). In other words, the sample No. 1-1-2 to sample No. 1-4-2 were made by depositing the ITO layer forming the transparent electrode 62, and thereafter first performing the pure water ultrasonic cleaning and the oxygen plasma process as illustrated in Table 2. The pure water ultrasonic cleaning and the oxygen plasma process were performed similarly as in the case of the sample No. 1-1-1 to sample No. 1-4-1.

Next, each sample was made by placing the sample in various states illustrated in Table 2, until depositing the Al layer forming the metal electrode 64.

More particularly, the sample No. 1-1-2 was made by depositing the metal layer 64 immediately after performing the pure water ultrasonic cleaning and the oxygen plasma process.

The sample No. 1-2-2 was made by performing the pure water ultrasonic cleaning and the oxygen plasma process, thereafter leaving the sample to stand within the normal room, that is, in the atmospheric environment for 1 day, and thereafter depositing the metal electrode 64 using the vacuum deposition apparatus.

In addition, the sample No. 1-3-2 and the sample No. 1-4-2 were made by performing the pure water ultrasonic cleaning and the oxygen plasma process, thereafter leaving the sample to stand within the clean room, that is, in the clean atmospheric environment for 1 day, and thereafter performing the pure water ultrasonic cleaning under the same conditions as the pure water ultrasonic cleaning that was carried out after depositing the transparent electrode 62. Further, the sample No. 1-3-2 was made by simply depositing the metal electrode 64 using the vacuum deposition apparatus. The sample No. 1-4-2 was made by performing an oxygen plasma process under the same conditions as the oxygen plasma process that was performed after depositing the transparent electrode 62, and thereafter depositing the metal electrode 64 using the vacuum deposition apparatus.

Table 1

| Sample No. | State Between Deposition of Each layer | |
|---|---|---|
| | Between Transparent Electrode & Barrier layer | Between Barrier Layer & Metal Electrode |
| 1-1-1 | Pure Water Ultrasonic Cleaning & Oxygen Plasma Process | Continuous Deposition Within Vacuum |
| 1-2-1 | | Left To Stand Within Laboratory For 1 Day |
| 1-3-1 | | Left To Stand Within Clean Room For 1 Day & Pure Water Ultrasonic Cleaning |
| 1-4-1 | | Left To Stand Within Clean Room For 1 Day & Pure Water Ultrasonic Cleaning & Oxygen Plasma Process |

Table 2

| Sample No. | State Between Deposition of Each layer | | |
|---|---|---|---|
| | Between Transparent Electrode & Metal Electrode | | |
| 1-1-2 | Pure Water Ultrasonic Cleaning & Oxygen Plasma Process | ⇒ | Continuous Deposition |
| 1-2-2 | | | Left To Stand Within Laboratory For 1 Day |
| 1-3-2 | | | Left To Stand Within Clean Room For 1 Day & Pure Water Ultrasonic Cleaning |
| 1-4-2 | | | Left To Stand Within Clean Room For 1 Day & Pure Water Ultrasonic Cleaning & Oxygen Plasma Process |

[Evaluation Method]

(1) Contact Resistance Measuring and Computing Method

First, the resistance value of the entire circuit connected by the metal electrode 64 is computed by applying a voltage across measuring points 65 and 66 indicated by x-marks in FIG. 6 (A) on the transparent electrode 62 and measuring the current. Next, the resistance value for the case in which the conduction takes place within the transparent electrode 62 and within the metal electrode 64 in an in-plane direction in FIG. 6 (A), is subtracted from the computed resistance value of the entire circuit connected by the metal electrode 64. By subtracting the resistance value for the case in which the conduction takes place within the transparent electrode 62 and the metal electrode 64 in the in-plane direction, from the measured resistance value of the entire circuit, it is possible to compute the resistance for the case in which the conduction takes place from the transparent electrode 62 in a laminating direction of the barrier layer 63 and the metal layer 64, as indicated by an arrow C in FIG. 6 (B), that is, the contact resistance. the resistances computed for the sample No. 1-1-2 to the sample No. 1-4-2 are the resistances (contact resistances) for the case in which the conduction takes place from the transparent electrode 62 to the metal electrode 64 in the laminating direction.

When evaluating each of the samples, the contact resistance was first measured after making each sample, each sample was stored in a temperature controlled bath at 105°C within an atmospheric environment, and the contact resistance was measured and computed at predetermined time intervals. Because the value of the contact resistance may vary depending on the applied voltage as illustrated in FIG. 4 (A), the measurement was performed for every 0.5 V between 0.5 V and 2 V, and an average value of the measure values was regarded as the contact resistance.

(2) Method of Computing Rate of Increase of Power Consumption

First, as a precondition, an element having a light emitting region of 80 mm□ and is driven by a current of 0.275 [A] and a voltage of 7 [V] was regarded as an original element. An element (hereinafter referred to as "segmented element") was obtained by segmenting the light emitting region of this original element into 3 segments and connecting the segments in series. A rate of increase of the power consumption of this segmented element as compared to that of the original element was computed as the power consumption increase rate.

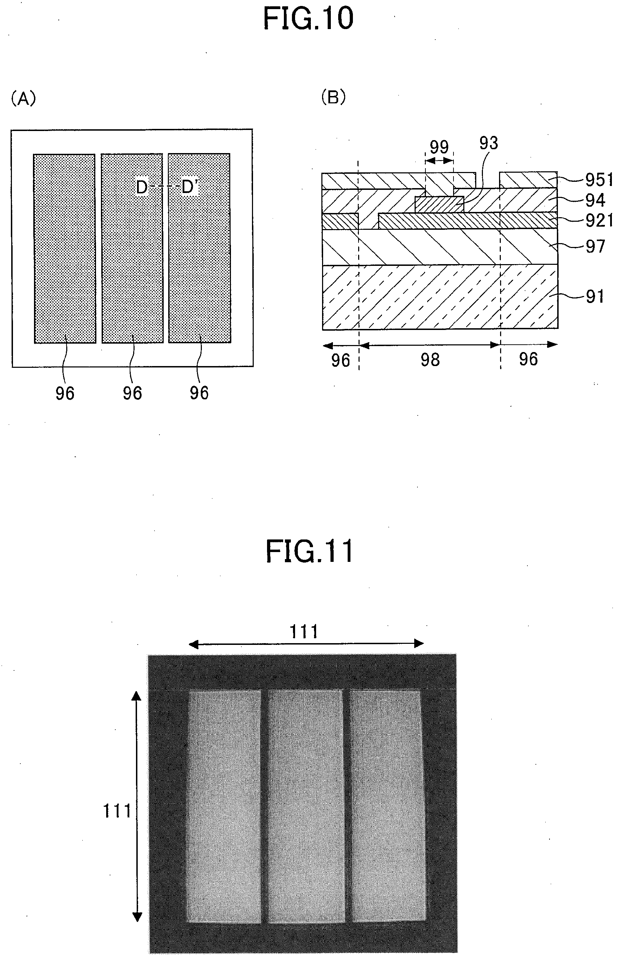

More particularly, the segmented element is assumed to have a structure in which the light emitting region is segmented into 3 light emitting regions along one side, as illustrated in FIG. 10 (A) which will be described later, for example, the contact region is arranged between the light emitting regions, and the light emitting regions are connected in series. In this case, with respect to 1 section of the light emitting region after the segmenting, it is required to drive with a current of 0.275/3 [A] in order to obtain the same luminance as the original element, and the voltage becomes 7 [V] because the resistance becomes (7/0.275) x 3 [Ω].

On the other hand, with respect to the contact region, the current became 0.275/3 [A] that is the same as that of the light emitting region, and the voltage became a value according to the measure and computed contact resistance. Further, the size of the contact region was assumed to be 0.5 x 80 mm$^2$. The power consumption of the entire element was computed from the above described conditions and the value of the measured and computed contact resistance, and after obtaining a difference between the power consumption of the original element and the power consumption of the segmented element, the power consumption increase rate was computed according to the following formula.

$$
\begin{aligned}
\text{(Power Consumption Increase Rate)} = [\{&\text{(Power} \\
\text{Consumption of Entire Segmented Element)} - (&\text{Power} \\
\text{Consumption of Original Element)}\}/(&\text{Power Consumption of} \\
\text{Original Element)}]\ \text{x}\ 100&
\end{aligned}
$$

Because the power consumption depends on the layer structure, materials used, segmented number, or the like of the organic LED element, the values computed by the above described method are merely examples.

(3) Method of Analyzing O Concentration at Interface Between Barrier Layer and Metal Electrode

First, Ar$^+$ ions accelerated to 1 kV scanned within a region of 2 mm square, including the region formed with the barrier layer 63, for 0.5 minute from the side of the metal electrode 64 of the sample that is made, to etch the sample. Next, an elemental analysis of the sample surface of the etched region was performed using an XPS (model: PHI Quantera SXM manufactured by Ulvac-Phi, Incorporated). Thereafter, the etched region was further subjected to etching and elemental analysis which were alternately repeated under the above described conditions, in order to obtain an element profile in the depth direction.

Immediately after the etching starts, Al forming the metal electrode 64 was mainly detected, but towards the interface with the barrier layer 63, the detection intensity of Al gradually decreased, and the detection intensity of Cr gradually increased. The width ΔZ of the depth where the Al detection intensity becomes 84% that within the metal electrode 64, that is, within the Al layer, and the depth where the Al detection intensity becomes 16% that within the metal electrode 64, was defined as forming the interface region. The average value of the O detection intensity in this interface region was regarded as the O concentration.

(Evaluation Results)

The evaluation was performed with respect to the sample No. 1-1-1 to the sample No. 1-4-1 and the sample No. 1-1-2 to the sample No. 1-4-2, according to the evaluation method described above. The evaluation results will be described hereunder.

A description will first be given of results of a test in which, after measuring the contact resistance with respect to each sample immediately after each sample is made, each sample is stored in the temperature controlled bath at 105°C to emphasize variation with time, as in the'method of measuring and computing the contact resistance described above.

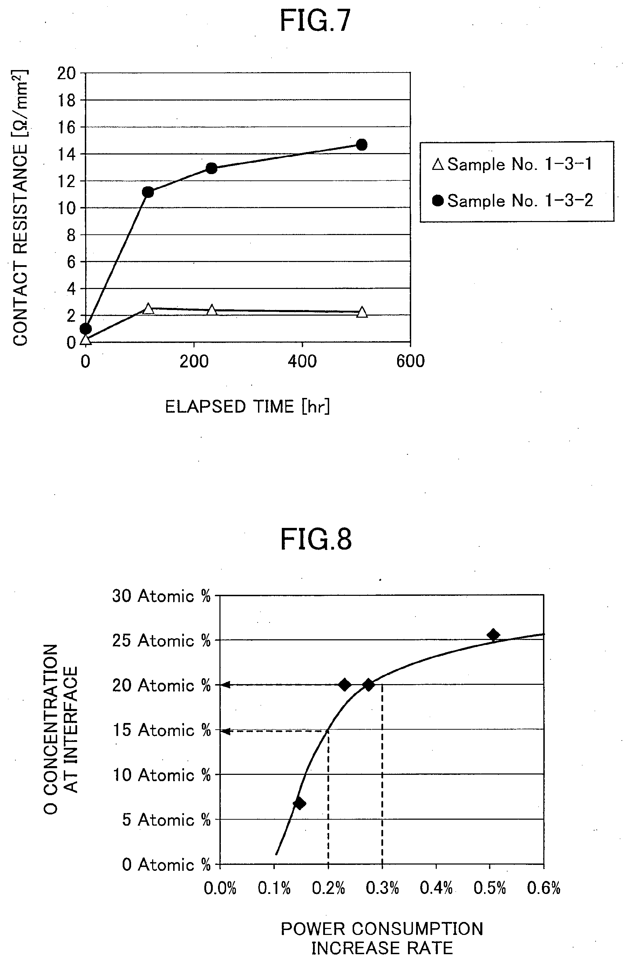

As an example of measured results, FIG. 7 illustrates the variation with time of the contact resistance for the sample No. 1-3-1 and the sample No. 1-3-2. The illustrated contact resistance is the average value of the measured values for the applied voltages of 0.5 V to 2 V, as described above. An elapsed time indicated by the ordinate in FIG. 8 indicates the elapsed time from a time when the storage of each sample in the temperature controlled bath at 105°C started.

From the results illustrated in FIG. 7, it may be confirmed that the value of the contact resistance is low at any point in time for the sample No. 1-3-1 having the barrier layer 63, as compared to the sample No. 1-3-2 having no barrier layer 63.

It may be regarded that the contact resistance of the sample No. 1-3-2 having no barrier layer 63 becomes high, because the oxygen within the ITO layer forming the transparent electrode 62 diffuses to the Al layer forming the metal electrode 64 with lapse of time, to form Al$_2$O$_3$ which is a non-conductor at the interface. On the other hand, in the case of the sample No. 1-3-1 having the barrier layer 63, it may be regarded that the rise in the contact resistance is small because the formation of $Al_2O_3$ is prevented. Accordingly, it was confirmed that the barrier layer 63 has the effect of suppressing the rise in the contact resistance.

Table 3 illustrates measured values of the contact resistance of each sample after storing each sample in the temperature controlled bath at 105°C for 120 hours [hr]. The illustrated contact resistance is also the average value of the measured values for the applied voltages of 0.5 V to 2 V, as described above. As is evident from the results illustrated in FIG. 7, the contact resistance of the sample rapidly rises immediately after storage of the sample in the temperature controlled bath starts, however, the rapid rise in the contact resistance is stopped after the sample is stored for 120 hours.

In addition, for reference purposes, Table 3 also illustrates in brackets under the column illustrating the contact resistance, the power consumption increase rate that is computed under the predetermined condition assumed from the value of the contact resistance that is measured and computed, as described in the evaluation method described above.

Furthermore, Table 3 also illustrates the O concentration at the interface between the barrier layer 63 and the metal electrode 64, detected by the XPS according to the method of analyzing the O concentration described above.

Table 3

| Sample No. | Contact Resistance [$\Omega/mm^2$] (Power Consumption Increase Rate) | O Concentration of Interface Between Barrier Layer & Metal Electrode |
|---|---|---|
| 1-1-1 | 1.3 (0.15%) | 6.8 Atomic % |
| 1-2-1 | 2.1 (0.23%) | 19.8 Atomic % |
| 1-3-1 | 2.5 (0.27%) | 20.0 Atomic % |
| 1-4-1 | 4.6 (0.51%) | 25.5 Atomic % |
| 1-1-2 | 3 (0.33%) | |
| 1-2-2 | 6.4 (0.71%) | |
| 1-3-2 | 11.1 (1.23%) | |
| 1-4-2 | 6.5 (0.72%) | |

When the sample No. 1-1-1 to the sample No. 1-4-1 illustrated in Table 3 are compared, it was confirmed that, the higher the O concentration at the interface between the barrier layer and the metal electrode, the contact resistance or the power consumption increase rate tends to become higher.

In addition, FIG. 8 illustrates a relationship between the power consumption increase rate and the O concentration at the interface of the sample No. 1-1-1 to the sample No. 1-4-1. The power consumption increase rate is preferably low, and it is preferable to suppress the power consumption increase rate to 0.3% or lower, for example. In order to make the power consumption increase rate 0.3% or lower, it may be confirmed from FIG. 8 that the O concentration at the interface between the barrier layer and the metal electrode preferably is approximately 20 atomic% or lower.

In addition, it is more preferable to suppress the power consumption increase rate to 0.2% or lower, and in order to make the power consumption increase rate 0.2% or lower, it may be confirmed from FIG. 8 that the O concentration at the interface between the barrier layer and the metal electrode preferably is 15 atomic% or lower.

[Exemplary Implementation 1]

In this exemplary implementation, the organic LED element having the series-connected structure illustrated in FIG. 1 was actually made and evaluated.

Glass substrate PD200 manufactured by Asahi Glass Company, Limited having a size of 100 mm square was used for the glass substrate (substrate).

In order to increase the light extraction efficiency from the organic LED element, a scattering layer made of glass was made on the glass substrate according to the following procedures.

First, powder materials were adjusted so that glass compositions illustrated in Table 4 are obtained, and the glass compositions were melted in an electric furnace at 1200°C and cast into rolls to obtain glass flakes. The obtained glass had a glass transition temperature of 462°C, a coefficient of thermal expansion of $78 \times 10^{-7}$ (1/°C) (average value for 50°C to 300°C), and a refractive index nd of 1.912 with respect to the D line (587.56 nm).

Table 4

|  | (mol%) | (wt%) |
|---|---|---|
| $B_2O_3$ | 40.6 | 18.9 |
| $Bi_2O_3$ | 19.3 | 60.2 |
| ZnO | 34.2 | 18.6 |
| $SiO_2$ | 5.9 | 2.4 |

After grinding the flakes that are made for 2 hours by a planetary mill made of zirconia, glass power having an average grain diameter of 1 $\mu$m or greater and 2 $\mu$m or less was made by sieving the flakes that were ground. The average grain diameter refers to the grain diameter at 50% the integrated value in the grain distribution obtained by laser analysis and scattering method.

Next, the glass powder obtained was mixed with zirconia powder that is a scatterer, and an organic vehicle, to make a glass paste. Ratio of components at the time of the mixing was 38 weight % organic vehicle, 62 weight % for a combined solid of glass powder and zirconia powder, and 7 volume % zirconia powder within the solid. In addition, the zirconia powder used had a powder grain diameter distributed from 200 nm or greater to 500 nm or less, and the refractive index at a wavelength of 550 nm was 2.22.

The glass paste made by the procedures described above was printed on the entire surface of a surface of the glass substrate on which the organic LED element is formed, with a uniform thickness, so that the layer thickness on the glass substrate after the sintering becomes 15 $\mu$m. Next, the glass paste printed on the glass substrate was dried at 150°C for 30 minutes, thereafter once returned to room temperature, and the temperature was raised to 450°C in 45 minutes and held at 450°C for 30 minutes. In addition, the temperature was further raised to 560°C in 11 minutes, held at 560°C for 30 minutes, and lowered to room temperature in 3 hours, so as to form the scattering layer made of glass on the glass substrate.

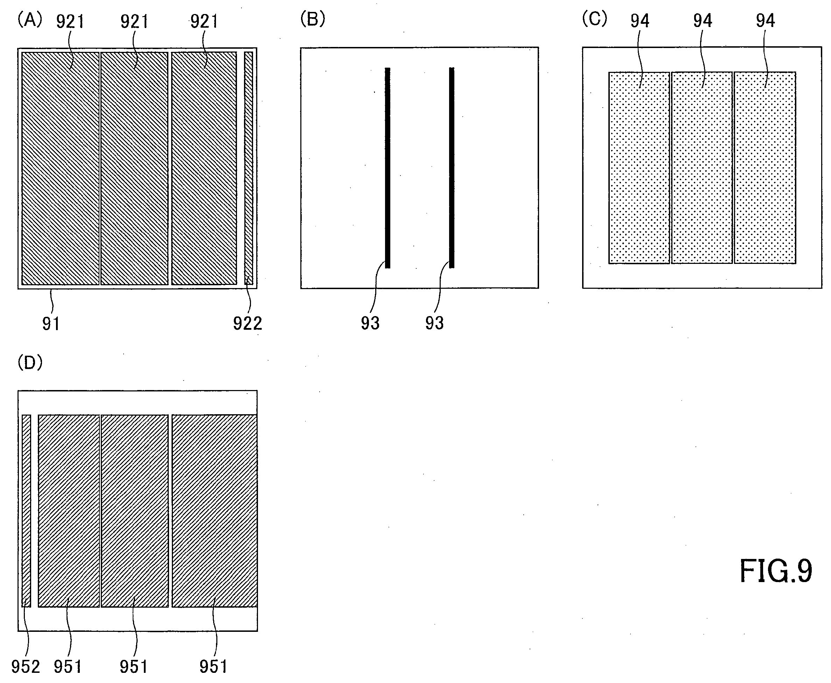

Next, an ITO layer was formed as the transparent electrode (first electrode) by the DC magnetron sputtering apparatus (model: SLC-38S manufactured by Shimadzu Corporation), using a mask. As illustrated in FIG. 9 (A), a transparent electrode 921 was formed at 3 locations in a strip shape (rectangular shape) in correspondence with each of the light emitting regions, and a transparent electrode 922 that becomes an anode electrode was formed at the right end in FIG. 9 (A), on the surface of a glass substrate 91 formed with the scattering layer. The transparent electrodes 921 and 922 were both deposited to a layer thickness of 150 nm. Each of FIG. 9 (A) and FIG. 9 (B) through (D) which will be described layer illustrate a diagram viewed from a direction perpendicular to the surface of the glass substrate on which the organic LED element is formed.

Next, ultrasonic cleaning using pure water was performed, and oxygen plasma was irradiated, in order to clean the surfaces of the transparent electrodes 921 and 922. The ultrasonic cleaning using pure water dipped the sample in pure water, and was performed for 10 minutes using the ultrasonic cleaning apparatus (model: AUTO PURSE 1200·28F manufactured by Kaijo Corporation). In addition, the oxygen plasma process was performed for 7 minutes under an oxygen atmosphere using the oxygen plasma process apparatus (model: QUICK COATER SC-706 manufactured by Sanyu Electron Co. Ltd.).

Next, as illustrated in FIG. 9 (B), a Cr layer was deposited as a barrier layer 93 to a layer thickness of 50 nm, using the vacuum deposition apparatus (model: Try-ELVES020G manufactured by Tokki Corporation Ltd.). The barrier layer 93 was deposited using a mask so as to have a line shape illustrated in FIG. 9 (B). In FIG. 9 (B), the illustration of the transparent electrodes 921 and 922 is omitted to facilitate understanding of the shape of the barrier layer 93.

After depositing the barrier layer 93, the sample is held in the vacuum state without exposing the sample to the atmosphere, and the same vacuum deposition apparatus is used to continuously deposit an organic layer (light emitting part) 94 illustrated in FIG. 9 (C) and metal electrodes (second electrodes) 951 and 952 illustrated in FIG. 9 (D) in the vacuum. As illustrated in FIG. 9 (C) and FIG. 9 (D), the organic layer 94 and the metal electrode 951 are deposited to strip shapes (rectangular shapes) in correspondence with each of the light emitting regions, using masks. In addition, as illustrated in FIG. 9 (D) for the metal electrodes, the metal electrode 952 that becomes a cathode electrode was deposited on the left end in FIG. 9 (D), using a mask.

In FIG. 9 (C), the illustration of parts other than the glass substrate and the organic layer 94 is omitted, in order to facilitate understanding of the shape of the organic layer 94. Further, in FIG. 9 (D), the illustration of parts other than the glass substrate and the metal electrodes 951 and 952 is omitted, in order to facilitate understanding of the shapes of the metal electrodes 951 and 952.

The organic layer 94 has a structure in which a CuPc (copper phthalocyanine) layer that forms a hole injecting layer, an $\alpha$-NPD (N,N'-diphenyl-N,N'-bis(1-naphthyl)- 1,1'-biphenyl-4,4'-diamine) layer that forms a hole transport layer, and an $Alq_3$ (tris(8-quinolinolate) aluminum complex) layer that forms an emissive layer, are stacked. The CuPc layer was deposited to a layer thickness of 20 nm, the α-NPD layer was deposited to a layer thickness of 100 nm, and the Alq₃ layer was deposited to a layer thickness of 60 nm.

The metal electrodes 951 and 952 are stacked layer electrodes in which Al layer is deposited on an LiF layer that forms an electron injecting layer and is deposited by thin film deposition. The LiF layer was deposited to a layer thickness of 0.5 nm, and the Al layer was deposited to a layer thickness of 80 nm.

When a voltage is applied across the anode electrode (+ terminal) and the cathode electrode (-terminal) of the organic LED element that is made by the steps described above, light emitting regions 96 illustrated in FIG. 10 (A) emit light. FIG. 10 (A) is a diagram illustrating a view from the direction perpendicular to the surface of the glass substrate on which the organic LED element is formed.

FIG. 10 (B) illustrates a cross sectional view along a dotted line D-D' in FIG. 10 (A). A illustrated in FIG. 10 (B), the transparent electrode 921 is stacked on the glass substrate 91 via a scattering layer 97, and the barrier layer 93 and the organic layer 94 are stacked on the transparent electrode 921. Further, the metal electrode 951 is deposited on the barrier layer 93 and the organic layer 94. In the case of the structure illustrated in FIG. 10 (B), a region where the transparent electrode 921 and the metal electrode 951 oppose each other becomes the light emitting region 96, and a non-light emitting region 98 is formed between the light emitting regions 96. Moreover, a region where the transparent electrode 921, the barrier layer 93, and the metal electrode 951 are stacked becomes a contact region 99.

Between the layers in the contact region 99 of the organic LED element that is made by the steps described above, the pure water ultrasonic cleaning and the oxygen plasma process are performed between the ITO layer forming the transparent electrode 921 and the Cr layer forming the barrier layer 93. In addition, the deposition is performed continuously within the vacuum deposition apparatus from the start of depositing the barrier layer 93 to the end of depositing the metal electrode 951, and continuous deposition is performed within the vacuum between the Cr layer forming the barrier layer 93 and the Al layer forming the metal electrode 951. Accordingly, at least the interface region between the Cr layer forming the barrier layer 93 and the Al layer forming the metal electrode 951, the C concentration is 10 atomic % or lower, the O concentration is 20 atomic % or lower, and the H concentration is 5 atomic % or lower.

The contact resistance at the contact region 99 in this exemplary implementation is in a state similar to that of the sample No. 1-1-1 of the reference example 1, and it may be regarded that the increase in the power consumption is small. Unlike the reference example 1, this exemplary implementation includes in the metal electrode 521 the LiF layer that forms the electron injecting layer, however, the layer thickness of the LiF layer is 0.5 nm and extremely thin, and the LiF layer includes micro openings, such that the contact resistance is virtually unaffected thereby.

FIG. 11 illustrates a photograph of a state at a time of light emission by applying a voltage to the organic LED element that is actually made. The organic LED element illustrated in FIG. 11 has the structure described above in which the 3 light emitting regions are arranged in parallel, the non-light emitting region is arranged between the light emitting regions, and the 3 light emitting regions are arranged in a square region having each side 111 with a length of 80 mm.

As is evident from the photograph of each light emitting region illustrated in FIG. 11, from the external appearance, it was confirmed that no problems caused by segmenting the light emitting region and connecting the segmented regions in series exist. In addition, in a case in which the contact resistance is high, generation of heat may be anticipated in a vicinity of the contact region due to the increase in the power consumption, however, no heat generation was observed in the vicinity of the contact region in the organic LED element illustrated in FIG. 11.

For comparison purposes, organic LED elements were made in which the light emitting region is not segmented into regions having the size of 80 mm square. However, it was confirmed that a current that is approximately 3 times larger is required to obtain the same luminance as the organic LED element illustrated in FIG. 11. In other words, according to the organic LED element in this exemplary implementation, it was confirmed that the amount of current can greatly be reduced compared to the organic LED elements in which the light emitting region is not segmented into the plurality of regions.

[Reference Example 2]

In the examples of the reference example 1 and the exemplary implementation 1, the ITO layer is used as the transparent electrode. On the other hand, in this reference example, the organic LED element was made using GZO (ZnO-Ga₂O₃) that is known to be more moderately priced than ITO.

First, the sample having the structure illustrated in FIG. 6 was made and evaluated, similarly to the sample No. 1-1-1 of the reference example 1, except that GZO was used for the transparent electrode. The evaluation results of the sample that is made are illustrated in Table 5 which will be described later, as evaluation results of a sample No. 2-1.

A description will be given of the state between each of the layers of the sample for which the contact resistance is evaluated. The pure water ultrasonic cleaning and the oxygen plasma process are performed between the GZO layer forming the transparent electrode 62 and the Cr layer forming the barrier layer 63. In addition, the deposition is performed continuously within the vacuum deposition apparatus from the start of deposing the barrier layer 63 to the end of depositing the metal electrode 64, and continuous deposition is performed within the vacuum between the Cr layer forming the barrier layer 63 and the Al layer forming the metal electrode 64.

Table 5 illustrates the contact resistance that is measured when the sample that is made is stored within an atmospheric environment with the temperature controlled to 105°C and 120 hours elapses from the start of storing the sample. For comparison purposes, Table 5 also illustrates the results obtained for the sample No. 1-1-1 of the reference example 1. The contact resistance was measured by a method similar to that described for the reference example 1.

Table 5

| Sample No. | Transparent Electrode Material | State Between Deposition of Each layer | | Contact Resistance [$\Omega$/mm$^2$] (Power Consumption Increase Rate) |
| | | Between Transparent Electrode & Barrier Layer | Between Barrier Layer & Metal Electrode | |
| --- | --- | --- | --- | --- |
| 2-1 | GZO | Pure Water Ultrasonic Cleaning & Oxygen Plasma Process | Continuous Deposition Within Vacuum | 0.3 (0.03%) |
| 1-1-1 | ITO | | | 1.3 (0.15%) |

According to Table 5, the contact resistance for the case in which GZO is used was 0.3 $\Omega$/mm$^2$, and it was confirmed that this contact resistance is lower than that for the case of the sample No. 1-1-1 in which the ITO layer was used as the transparent electrode. In addition, the power consumption increase rate that is computed from the measured contact resistance, by a method similar to that used in the reference example 1, was 0.03%, and it was confirmed that the power consumption increase rate is sufficiently small.

[Exemplary Implementation 2]

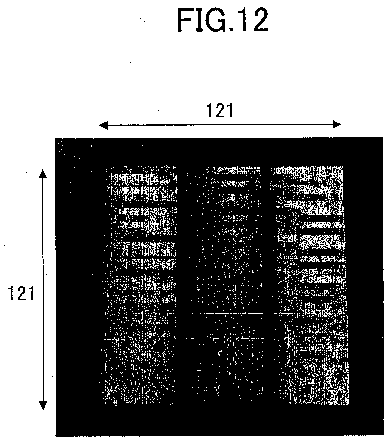

In this exemplary implementation, the organic LED element was made according to procedures similar to that of the exemplary implementation 1, except that no scattering layer was formed on the glass substrate, the GZO layer was used in place of the ITO layer for the transparent electrodes 921 and 922, and the layer thickness of the GZO layer was 450 nm. FIG. 12 illustrates a photograph of a state at a time of light emission by applying a voltage to the organic LED element that is actually made. The organic LED element illustrated in FIG. 12 has the structure described above in which the 3 light emitting regions are arranged in parallel, the non-light emitting region is arranged between the light emitting regions, and the 3 light emitting regions are arranged in a square region having each side 121 with a length of 80 mm, similarly to the case of the exemplary implementation 1.

With respect to the organic LED element in this exemplary implementation, the deposition is performed continuously within the vacuum deposition apparatus from the start of depositing the barrier layer 93 to the end of depositing the metal electrode 951, and continuous deposition is performed within the vacuum between the Cr layer forming the barrier layer 93 and the Al layer forming the metal electrode 951. Accordingly, at least the interface region between the Cr layer forming the barrier layer 93 and the Al layer forming the metal electrode 951, the C concentration is 10 atomic % or lower, the O concentration is 20 atomic % or lower, and the H concentration is 5 atomic % or lower.

In addition, as illustrated in FIG. 12 and similarly to the exemplary implementation 1 that uses the ITO layer for the transparent electrode, it was confirmed from the external appearance that no problems exist. Moreover, it was also confirmed that no heat generation occurs in the vicinity of the contact region, similarly to the exemplary implementation 1.

Although the organic LED element and the method of manufacturing the organic LED element are described heretofore in conjunction with embodiments, exemplary implementations, or the like, the present invention is not limited to the above embodiments, exemplary implementations, or the like, and various variations and modifications may be made within the scope of the present invention recited in the claims.

This international application is based upon and claims the benefit of priorities of Japanese Patent Application No. 2013-105474 filed on May 17, 2013 and Japanese Patent Application No. 2014-016984 filed on January 31, 2014, and the entire contents of Japanese Patent Application No. 2013-105474 and Japanese Patent Application No. 2014-016984 are incorporated herein by reference.

DESCRIPTION OF REFERENCE NUMERALS

11, 11A, 11B, 96 Light Emitting Region
21, 91 Substrate
22, 921, 922 First Electrode

24, 951, 952 Second Electrode
25, 93 Barrier Layer
52 Interface Region
53 Compatible Layer

**Claims**

1. An organic LED element comprising a plurality of light emitting regions that are coupled in series, wherein
   the light emitting regions include a first electrode and a second electrode,
   between two adjacent light emitting regions, the first electrode of one light emitting region and the second electrode of another light emitting region are connected via a barrier layer, and
   a C concentration in an interface region between the first electrode and the barrier layer, or an interface region between the second electrode and the barrier layer, is 10 atomic % or lower.

2. An organic LED element comprising a plurality of light emitting regions that are coupled in series, wherein
   the light emitting regions include a first electrode and a second electrode,
   between two adjacent light emitting regions, the first electrode of one light emitting region and the second electrode of another light emitting region are connected via a barrier layer, and
   an 0 concentration in an interface region between the second electrode and the barrier layer is 20 atomic % or lower.

3. An organic LED element comprising a plurality of light emitting regions that are coupled in series, wherein
   the light emitting regions include a first electrode and a second electrode,
   between two adjacent light emitting regions, the first electrode of one light emitting region and the second electrode of another light emitting region are connected via a barrier layer, and
   an H concentration in an interface region between the first electrode and the barrier layer, or an interface region between the second electrode and the barrier layer, is 5 atomic % or lower.

4. The organic LED element as claimed in any of claims 1 to 3, wherein the interface region between the first electrode and the barrier layer includes a compatible layer.

5. The organic LED element as claimed in any of claims 1 to 4, wherein the interface region between the second electrode and the barrier layer includes a compatible layer.

6. The organic LED element as claimed in any of claims 1 to 5, wherein the barrier layer is formed by a metal or an alloy of the metal including one or more elements selected from Cr, Mo, Ti, Ta, Pd, and Pt.

7. The organic LED element as claimed in any of claims 1 to 6, wherein
   the organic LED element is formed on a substrate, and the substrate includes a light extracting layer.

8. A method of manufacturing an organic LED element having a plurality of light emitting regions that are coupled in series, comprising:

   a first electrode forming step to form a first electrode;
   a barrier forming step to form a barrier layer; and
   a second electrode forming step to form a second electrode,
   wherein each of the steps is carried out under an atmosphere in which a C concentration is $5.0 \times 10^{21}$ atoms/m$^3$ or lower, at least during a time from a start of the first electrode forming step to an end of the barrier layer forming step, or during a time from a start of the barrier layer forming step to an end of the second electrode forming step.

9. A method of manufacturing an organic LED element having a plurality of light emitting regions that are coupled in series, comprising:

   a first electrode forming step to form a first electrode;
   a barrier forming step to form a barrier layer; and
   a second electrode forming step to form a second electrode,
   wherein each of the steps is carried out under an atmosphere in which an O concentration is $5.0 \times 10^{24}$ atoms/m$^3$ or lower, at least during a time from a start of the first electrode forming step to an end of the barrier layer forming step, or during a time from a start of the barrier layer forming step to an end of the second electrode forming step.

10. A method of manufacturing an organic LED element having a plurality of light emitting regions that are coupled in series, comprising:

a first electrode forming step to form a first electrode;
a barrier forming step to form a barrier layer; and
a second electrode forming step to form a second electrode,
wherein each of the steps is carried out under an atmosphere in which an H concentration is $5.0 \times 10^{22}$ atoms/m$^3$ or lower, at least during a time from a start of the first electrode forming step to an end of the barrier layer forming step, or during a time from a start of the barrier layer forming step to an end of the second electrode forming step.

11. The method of manufacturing the organic LED element as claimed in any of claims 8 to 10, wherein the barrier layer is formed by a metal or an alloy of the metal including one or more elements selected from Cr, Mo, Ti, Ta, Pd, and Pt.

12. The method of manufacturing the organic LED element as claimed in any of claims 8 to 11, wherein the organic LED element is formed on a substrate, and the substrate includes a light extracting layer.

# FIG.1

# FIG.2

# FIG.3

FIG.4

(A)

(B)

EP 2 999 311 A1

# FIG.5

(A)

(B)

# FIG.6

(A)

(B)

## FIG.7

## FIG.8

(A) 921 921 921

91 922

(B)

93 93

(C) 94 94 94

(D)

952 951 951 951

EP 2 999 311 A1

FIG.9

# FIG.10

(A)

(B)

99   93

951
94
921
97
91

96     98     96

D----D'

96     96     96

# FIG.11

111

111

# FIG.12

**INTERNATIONAL SEARCH REPORT**

International application No.

PCT/JP2014/061162

A.    CLASSIFICATION OF SUBJECT MATTER
*H05B33/10*(2006.01)i, *H01L51/50*(2006.01)i, *H05B33/02*(2006.01)i, *H05B33/26*
(2006.01)i

According to International Patent Classification (IPC) or to both national classification and IPC

B.    FIELDS SEARCHED

Minimum documentation searched (classification system followed by classification symbols)
H05B33/10, H01L51/50, H05B33/02, H05B33/26

Documentation searched other than minimum documentation to the extent that such documents are included in the fields searched
Jitsuyo Shinan Koho          1922–1996    Jitsuyo Shinan Toroku Koho    1996–2014
Kokai Jitsuyo Shinan Koho    1971–2014    Toroku Jitsuyo Shinan Koho    1994–2014

Electronic data base consulted during the international search (name of data base and, where practicable, search terms used)

C.    DOCUMENTS CONSIDERED TO BE RELEVANT

| Category* | Citation of document, with indication, where appropriate, of the relevant passages | Relevant to claim No. |
|---|---|---|
| Y | JP 2012-151103 A  (Semiconductor Energy Laboratory Co., Ltd.), 09 August 2012 (09.08.2012), paragraphs [0089] to [0094], [0097], [0100], [0116], [0124] to [0185]; fig. 4 to 5 & US 2012/0161174 A1    & WO 2012/090889 A1 & TW 201242129 A        & CN 103262656 A | 1-12 |
| Y | JP 2000-150149 A  (Rohm Co., Ltd.), 30 May 2000 (30.05.2000), claims 1 to 2; paragraphs [0008] to [0011], [0017] to [0029]; fig. 1 to 2 & US 6338979 B1 | 1-12 |

☒  Further documents are listed in the continuation of Box C.          ☐  See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 27 May, 2014 (27.05.14) | 10 June, 2014 (10.06.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2014/061162

C (Continuation). DOCUMENTS CONSIDERED TO BE RELEVANT

| Category* | Citation of document, with indication, where appropriate, of the relevant passages | Relevant to claim No. |
|---|---|---|
| Y | JP 09-306668 A (Hokuriku Electric Industry Co., Ltd.), 28 November 1997 (28.11.1997), paragraphs [0011] to [0015], [0020]; fig. 3 (Family: none) | 1-12 |
| Y | JP 2011-243290 A (Hitachi, Ltd.), 01 December 2011 (01.12.2011), claims 1 to 3; paragraph [0004]; fig. 1 & US 2011/0278557 A1 & EP 2387085 A1 | 7,12 |
| A | JP 06-223971 A (Komatsu Ltd.), 12 August 1994 (12.08.1994), paragraphs [0002] to [0005] (Family: none) | 1-12 |

Form PCT/ISA/210 (continuation of second sheet) (July 2009)

**REFERENCES CITED IN THE DESCRIPTION**

**Patent documents cited in the description**

- JP 2000029404 A
- JP 3649238 B
- JP 2013105474 A
- JP 2014016984 A